(19) Europäisches Patentamt
European Patent Office
Office européen des brevets

(11) **EP 1 729 415 B1**

(12) **EUROPEAN PATENT SPECIFICATION**

(45) Date of publication and mention
of the grant of the patent:
**16.04.2014 Bulletin 2014/16**

(51) Int Cl.:
*H03H 9/145* *(2006.01)* *H03H 9/00* *(2006.01)*
*H03H 9/64* *(2006.01)*

(21) Application number: **05770560.0**

(22) Date of filing: **10.08.2005**

(86) International application number:
**PCT/JP2005/014672**

(87) International publication number:
**WO 2006/022143 (02.03.2006 Gazette 2006/09)**

(54) **BALANCED SURFACE ACOUSTIC WAVE FILTER**

SYMMETRISCHES OBERFLÄCHENWELLENFILTER

FILTRE D'ONDES ACOUSTIQUES DE SURFACE ÉQUILIBRÉES

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **23.08.2004 JP 2004242520**

(43) Date of publication of application:
**06.12.2006 Bulletin 2006/49**

(73) Proprietor: **MURATA MANUFACTURING CO., LTD.
Nagaokakyo-shi, Kyoto 617-8555 (JP)**

(72) Inventor: **TAKAMINE, Yuichi
c/o MURATA MANUFACTURING CO., LTD
Nagaokakyo-shi, Kyoto, 6178555 (JP)**

(74) Representative: **Joly, Jean-Jacques et al
Cabinet Beau de Loménie
158, rue de l'Université
75340 Paris cedex 07 (FR)**

(56) References cited:
**EP-A1- 1 276 235      EP-A1- 1 670 138
EP-A2- 1 152 529      EP-A2- 1 158 672
EP-A2- 1 280 274      JP-A- 2002 111 432
JP-A- 2004 048 675    JP-B2- 3 419 402
US-A1- 2003 227 359   US-B1- 6 420 946**

## Description

Technical Field

The present invention relates to a balanced-type surface acoustic wave filter provided with a balance-unbalance conversion function, and more particularly to a balanced-type surface acoustic wave filter in which an IDT has a narrow pitch electrode finger section and at the same time an input/output impedance ratio is set to a specific value.

Background Art

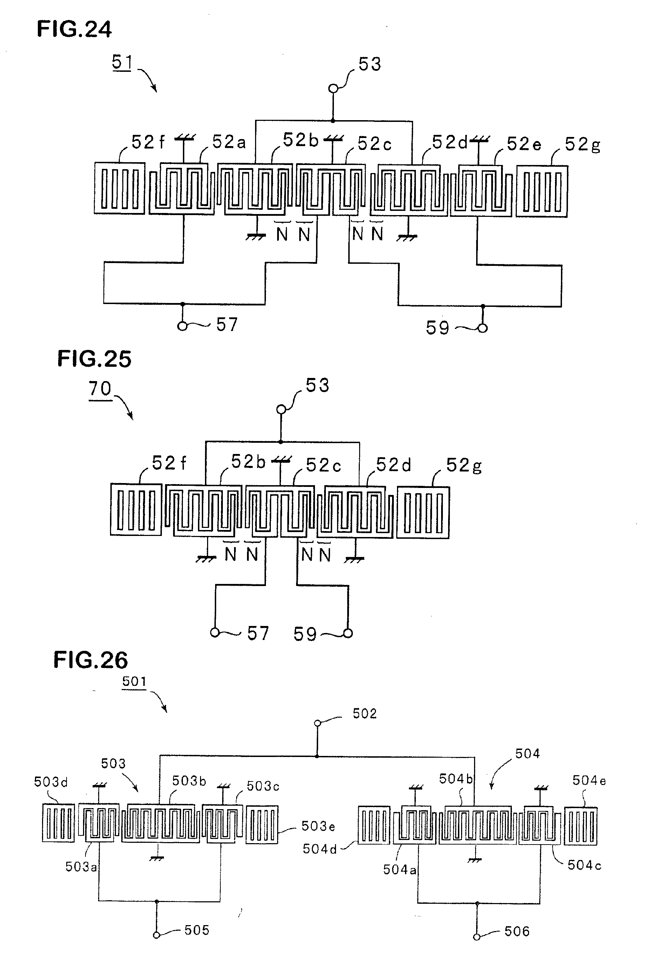

In the related art, a balanced-type surface acoustic wave filter provided with a balance-unbalance conversion function is widely used in communications equipment such as mobile phones. For example, Patent Document 1 described below discloses a balanced-type surface acoustic wave filter, which is shown in Fig. 26.

In a balanced-type surface acoustic wave filter 501 shown in Fig. 26, longitudinally coupled resonator type surface acoustic wave filters 503 and 504 are connected to an unbalanced input terminal 502. The surface acoustic wave filters 503 and 504 include the first to third IDTs (interdigital transducers) 503a to 503c and 504a to 504c arranged in the surface acoustic wave propagating direction, respectively. The second IDTs 503b and 504b in the center are electrically connected to the unbalanced input terminal 502. Then, in the surface acoustic wave propagating direction, the first and third IDTs 503a and 503c arranged on both the sides of the IDT 503b are electrically connected to a first balanced output terminal 505. On the other hand, the first and third IDTs 504a and 504c arranged on both the sides of the IDT 504b in the center of the surface acoustic wave filter 504 are electrically connected to a second balanced output terminal 506.

In the balanced-type surface acoustic wave filter 501, the input impedance on the unbalanced input terminal 502 side is set to 50 $\Omega$, and characteristic impedances on the sides of the first and second balanced output terminals 505 and 506 are set to 150 $\Omega$. That is, the input/output impedance ratio is set to 1:3. This is because an antenna is connected to an input terminal of the balanced-type surface acoustic wave filter 501 and the impedance is usually set to 50 $\Omega$, whereas the input impedance of an IC connected to the output side is set to 150 $\Omega$.

In the meantime, Patent Documents 2 and 3 described below respectively disclose balanced-type surface acoustic wave filters provided with a balance-unbalance conversion function similarly to the balanced-type surface acoustic wave filter described in Patent Document 1 but being different in electrode constructions. In the balanced-type surface acoustic wave filters described in Patent Documents 2 and 3 as well, the impedance ratio between the unbalanced signal terminal and the balanced signal terminal is set to about 1:3 to 1:4.

On the other hand, in recent years, a balanced-type mixer IC with input impedance of about 100 $\Omega$ is commercially available as an IC to be connected to the output side of the balanced-type surface acoustic wave filter of this kind. To cope with such an IC, it is required that the output impedance of the balanced-type surface acoustic wave filter connected to the IC is set to 100 $\Omega$. Then, to set the impedance on the input terminal side to 50 $\Omega$, an input/output impedance ratio of the surface acoustic wave filter is required to be 1:2.

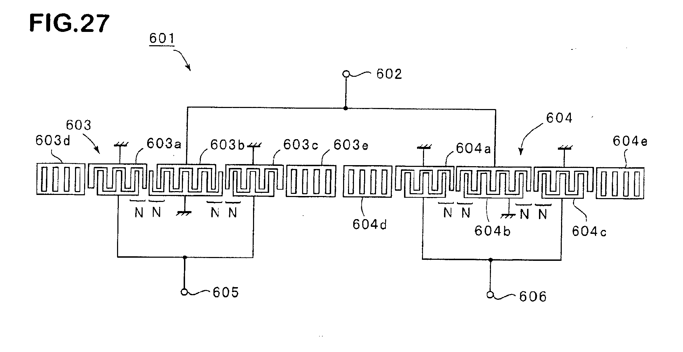

Patent Document 4 described below discloses a balanced-type surface acoustic wave filter provided with a balance-unbalance conversion function in which the impedance ratio between an unbalanced signal terminal and a balanced signal terminal is set to 1:2. Fig. 27 is a plan view showing the electrode construction of the balanced-type surface acoustic wave filter described in Patent Document 4. In a balanced-type surface acoustic wave filter 601, connected to an unbalanced input terminal 602 are longitudinally coupled resonator type surface acoustic wave filter sections 603 and 604. The longitudinally coupled resonator type surface acoustic wave filter sections 603 and 604 respectively include the first to third IDTs 603a to 603c and 604a to 604c arranged in the surface acoustic wave propagating direction. The IDTs 603b and 604b in the center are electrically connected to the unbalanced input terminal 602. The first and third IDTs 603a and 603c located on both sides of the IDT 603b in the surface acoustic wave propagating direction are electrically connected to a first balanced output terminal 605. In the same manner, in surface acoustic wave filter section 604, the IDTs 604a, 604c located on both sides of the IDT 604b in the surface acoustic wave propagating direction are electrically connected to the second balanced output terminal 606.

Here, the IDTs 603a and 603b include narrow pitch electrode finger sections N in the neighborhood of the areas adjacent to each other with a gap interposed therebetween in the surface acoustic wave propagating direction. That is, the electrode finger pitch of the area of IDT 603a near the IDT 603b has narrower electrode finger pitch as compared to the rest of the areas. This IDT area where the electrode finger pitch is relatively narrow is referred to as a narrow pitch electrode finger section N. In the same manner, the area of IDT 603b near the IDT 603a at the side end is provided with the narrow pitch electrode finger section N. Furthermore, in the IDTs 603b and 603c and IDTs 604a to 604c as well, the respective neighborhoods of the areas adjacent to the gap are provided with the narrow pitch electrode finger section N.

Then, Patent Document 4 describes that in the balanced-type surface acoustic wave filter 601, the IDT 603b and 604b on the unbalanced side and the IDTs 603a, 603c, 604a, and 604c on the balanced side are set to have different numbers of electrode fingers, whereby the input/output impedance ratio can be set to 1:2.

Patent Document 1: Japanese Unexamined Patent Application Publication No. 2001-308672
Patent Document 2: Japanese Unexamined Patent Application Publication No. 6-204781
Patent Document 3: Japanese Unexamined Patent Application Publication No. 11-97966
Patent Document 4: Japanese Unexamined Patent Application Publication No. 2004-48675

A similar device is disclosed in US 2003/0227359.

Disclosure of Invention

In the surface acoustic wave filter, the impedance of the IDT becomes smaller as an electrode finger cross width is larger and the number of electrode fingers is larger. In the surface acoustic wave filter 601 shown in Fig. 27, for example, the IDT 603b in the center of the surface acoustic wave filter section 603 is connected to the unbalanced input terminal 602, the IDTs 603a and 603c on both the sides are connected to the first balanced output terminal 605.

Therefore, to adjust the impedance ratio between the unbalanced signal terminal and the balanced signal terminal, the cross width of the IDT 603b and the cross widths of the IDTs 603a and 603c cannot be set different. Therefore, as described above, the number of electrode fingers of the IDT 603b on the unbalanced side and the number of electrode fingers of the IDTs 603a and 603c on the balanced side are made different from each other, and the input/output impedance ratio is changed. For example, the impedance of the first balanced output terminal becomes a value depending on the number of electrode fingers of the IDT 603a on the balanced side. This is because, the IDTs 603a and 603c are connected in parallel with respect to a balanced output terminal 605 and at the same time the balanced output terminal 605 and the balanced output terminal 606 are connected in series via an earth potential. In contrast to this, the impedance of the unbalanced terminal 602 side has a value corresponding to 1/2 of the number of electrode fingers of the IDT 603b on the unbalanced side. That is, when the number of electrode fingers of the IDT 603b on the unbalanced side is set to 1/2 of the number of electrode fingers of the IDT 603a on the balanced side, the impedance ratio between the unbalanced signal terminal and the balanced signal terminal can be set to 1:2.

However, the ratio between the numbers for the IDTs 603b and 604b on the unbalanced side and the numbers for the IDTs 603a, 603c, 604a, and 604c on both sides is changed, a problem occurs in that an influence is imparted to resonant frequencies of a plurality of resonant modes for obtaining a pass band of the surface acoustic wave filter 601. Thus, the number ratio cannot be changed significantly. Then, as the number for the IDT on the unbalanced side is much smaller than the numbers for the IDTs 603a and 603c on the balanced side, there is also a problem in that sufficient filter bandwidth cannot be obtained.

In addition, with a method of changing the ratio between the numbers of electrode fingers, the impedance ratio between the unbalanced signal terminal and the balanced signal terminal cannot be set to 1:2 with precision, and the set ratio is often shifted from 1:2.

An object of the present invention is to eliminate the above-mentioned drawbacks of the related art and to provide a surface acoustic wave filter provided with a balance-unbalance conversion function, in which the degree of freedom for adjusting impedances of a plurality of resonant modes for obtaining a pass band can be increased without degrading filter characteristics such as bandwidth and loss, and accordingly it is possible to easily set the impedance ratio between the unbalanced signal terminal and the balanced signal terminal to 1:2 or the like with precision, and also a sufficient band width is obtained.

A first aspect of the invention is a balanced-type surface acoustic wave filter connected to an unbalanced terminal and first and second balanced terminals and provided with a balance-unbalance conversion function, including: a piezoelectric substrate; a first surface acoustic wave filter section including first to third IDTs arranged along a surface acoustic wave propagating direction on the piezoelectric substrate, the second IDT in the center or the first and third IDTs on both the sides being connected to the unbalanced terminal, and the first and third IDTs on both sides or the second IDT in the center being connected to the first balanced terminal; and a second surface acoustic wave filter section including first to third IDTs arranged in the surface acoustic wave propagating direction on the piezoelectric substrate, the second IDT in the center or the first and third IDTs on both the sides being connected to the unbalanced terminal, the first and third IDTs on both sides or the second IDT in the center being connected to the second balanced terminal, and the second surface acoustic wave filter section being constructed to have a phase of an output signal to an input signal different by 180 degrees with respect to the first surface acoustic wave filter section, the balanced-type surface acoustic wave filter being characterized in that in the first and second surface acoustic wave filter sections, in a pair of IDTs adjacent to each other with a gap interposed therebetween in the surface acoustic wave propagating direction, a section where the pitch of a portion of the electrode fingers including an electrode finger facing the gap is smaller than the pitch of the electrode fingers of the main part of the IDT is set as a narrow pitch electrode finger section, and the electrode finger pitch of the narrow pitch electrode finger section of any IDT connected to the unbalanced terminal of the first and second surface acoustic wave filter sections being set as P1, the electrode finger pitch of any narrow pitch electrode finger section of the IDT connected to the balanced terminal being set as P2, the number of electrode fingers of the main electrode finger section outside the narrow pitch electrode finger section of any IDT connected to the unbalanced terminal of the first and second surface acoustic wave filter sections being set as K1, and the number of electrode fingers of the main electrode finger section outside the narrow pitch electrode finger section of any IDT connected to the balanced terminal being set as K2, so that the following relations:

$$P1 > P2;$$

and

$$1.12 \leq K1/K2 \leq 1.65$$

are satisfied.

According to a second aspect of the invention, in the above balanced-type surface acoustic wave filter when the number of electrode fingers of the narrow pitch electrode finger section of the IDT connected to the unbalanced terminal of the first and second surface acoustic wave filter sections is set as K1n, and the number of electrode fingers of the narrow pitch electrode finger section of the IDT connected to the balanced terminal is set as K2n, the following relations:

$$P1 > P2;$$

$$K1n = K2n;$$

and

$$1.12 \leq K1/K2 \leq 1.65$$

are satisfied.

In the balanced-type surface acoustic wave filters according to the first and second aspects, preferably, when a metallization ratio in the first and second surface acoustic wave filter sections is set as d and an electrode finger cross width is set as W, $67.4\lambda I \leq W/d \leq 74.3\lambda I$ (where $\lambda I$ denotes a wavelength of the IDT) is satisfied.

A third aspect of the invention is a balanced-type surface acoustic wave filter connected to a balanced terminal and first and second unbalanced terminals and provided with a balance-unbalance conversion function, including: a piezoelectric substrate; and first to third IDTs arranged on the piezoelectric substrate in a surface acoustic wave propagating direction, the balanced-type surface acoustic wave filter being characterized in that the second IDT is connected to the unbalanced terminal, and the first and third IDTs on both sides are respectively connected to the first and second balanced terminals, and in an area where the first to third IDTs are adjacent one another, the respective IDTs have narrow pitch electrode finger sections and an electrode finger pitch of the narrow pitch electrode finger section is set smaller than an electrode finger pitch of a main electrode finger section of the IDT provided with narrow pitch electrode fingers, and a phase of the first IDT is reversed by 180 degrees with respect to a phase of the third IDT, and the electrode finger pitch of any narrow pitch electrode finger section of the second IDT located in the center being set as P1, the electrode finger pitch of any narrow pitch electrode finger section of the first and third IDTs being set as P2, the number of electrode fingers of the main electrode finger section outside the narrow pitch electrode finger section of the second IDT being set as K1, and the number of electrode fingers of the main electrode finger section outside the narrow pitch electrode finger section of the first and third IDTs being set as K2, so that the following relations:

$$P1 > P2;$$

and

$$1.12 \leq K1/K2 \leq 1.65$$

are satisfied.

According to a fourth aspect of the invention, in the latter balanced-type surface acoustic wave filter when the number of electrode fingers of the narrow pitch electrode finger section of the second IDT is set as K1n, the number of electrode fingers of the narrow pitch electrode finger section of the first and third IDTs is set as K2n, the following relations:

$$P1 > P2;$$

$$K1n = K2n;$$

and

$$1.12 \leq K1/K2 \leq 1.65$$

are satisfied.

In the balanced-type surface acoustic wave filters according to the third and fourth aspects, preferably, when a metallization ratio in the first to third IDTs is set as d and an electrode finger cross width is set as W, $134.8\lambda I \leq W/d \leq 148.6\lambda I$ (where $\lambda I$ denotes a wavelength of the IDT) is satisfied.

A fifth aspect of the invention is a balanced-type surface acoustic wave filter connected to an unbalanced terminal and first and second balanced terminals and provided with a balance-unbalance conversion function, including: a piezoelectric substrate; and first to third IDTs arranged on the piezoelectric substrate in a surface acoustic wave propagating direction, the balanced-type surface acoustic wave filter being characterized in that the first and third IDTs located on both sides in the surface acoustic wave propagating direction are connected to the unbalanced terminal, the second IDT includes first and second IDT sections divided in the surface acoustic wave propagating direction and the first and second IDT sections are respectively electrically connected to the first and second balanced signal terminals, the first to third IDTs are constructed to set a phase of a signal emanating from the unbalanced terminal to the first balanced signal terminal reversed by 180 degrees with respect to a phase of a signal emanating from the unbalanced terminal to the second balanced signal terminal, and in an area where the first to third IDTs are adjacent to one another in the surface acoustic wave propagating direction with a gap interposed therebetween, a plurality of electrode fingers near the gap correspond to a narrow pitch electrode finger section where a pitch of the electrode fingers is relatively small, and the electrode finger pitch of the narrow pitch electrode finger section of the first and third IDTs connected to the unbalanced signal terminal being set as P1, the electrode finger pitch of any narrow pitch electrode finger section of the second IDT whose first and second IDT sections are respectively connected to the first and second balanced signal terminal being set as P2, the number of electrode fingers of the electrode finger section outside the narrow pitch electrode finger section of the first and third IDTs being set as K1, and the number of electrode fingers of the electrode finger section outside the narrow pitch electrode finger section of the second IDT being set as K2, so that the following relations:

$$P1>P2;$$

and

$$1.12 \leq K1/K2 \leq 1.65$$

are satisfied.

According to a sixth aspect of the invention, in the latter balanced-type surface acoustic wave filter when the number of electrode fingers of the narrow pitch electrode finger section of the first and third IDTs is set as K1n, and the number of electrode fingers of the narrow pitch electrode finger section of the second IDT is set as K2n, the following relations:

$$P1>P2;$$

$$K1n=K2n;$$

and

$$1.12 \leq K1/K2 \leq 1.65$$

are satisfied.

In the balanced-type surface acoustic wave filters according to the fifth and sixth aspects, preferably, when a metallization in the first to third IDTs is set as d and an electrode finger cross width is set as W, $134.8 \lambda I \leq W/d \leq 148.6 \lambda I$ (where $\lambda I$ denotes a wavelength of the IDT) is satisfied.

A seventh aspect of the invention is a balanced-type surface acoustic wave filter connected to an unbalanced terminal and first and second balanced terminals and provided with a balance-unbalance conversion function, including: a piezoelectric substrate; a first surface acoustic wave filter section including first to third IDTs arranged on the piezoelectric substrate along a surface acoustic wave propagating direction, the second IDT in the center or the first and third IDTs on both sides being connected to the unbalanced terminal, and the first and third IDTs on both sides or the second IDT in the center being connected to the first balanced terminal; and a second surface acoustic wave filter section including first to third IDTs arranged in the surface acoustic wave propagating direction on the piezoelectric substrate, the second IDT in the center or the first and third IDTs on both sides being connected to the unbalanced terminal, the first and third IDTs on both sides or the second IDT in the center being connected to the second balanced terminal, and the second surface acoustic wave filter section being constructed to have a phase of an output signal to an input signal different by 180 degrees with respect to the first surface acoustic wave filter section, the balanced-type surface acoustic wave filter being characterized in that in the first and second surface acoustic wave filter sections, in a pair of IDTs adjacent to each other with a gap interposed therebetween in the surface acoustic wave propagating direction, a section where the pitch of a portion of the electrode fingers including an electrode finger facing the gap is smaller than the pitch of the electrode fingers of a main part of the IDT is set as a narrow pitch electrode finger section, and the electrode finger pitch of the narrow pitch electrode finger section of any IDT connected to the unbalanced terminal of the first and second surface acoustic wave filter sections being set as P1, the number of electrode fingers of the narrow pitch electrode finger section thereof being set as N1, the electrode finger pitch of the narrow pitch electrode finger section of the IDT connected to the first and second balanced terminals being set as P2, and the number of electrode fingers of the narrow pitch electrode finger section thereof being set as N2, so that the following relations:

$$P1 \neq P2;$$

and

$$N1 < N2$$

are satisfied.

An eighth aspect of the invention is a balanced-type surface acoustic wave filter connected to a balanced terminal and first and second unbalanced terminals and provided with a balance-unbalance conversion function, including: a piezoelectric substrate; and first to third IDTs arranged on the piezoelectric substrate in a surface acoustic wave propagating direction, the balanced-type surface acoustic wave filter being characterized in that the second IDT is connected to the unbalanced terminal, and the first and third IDTs are respectively connected to the first and second balanced terminals, and in an area where the first to third IDTs are adjacent to one another, the respective IDTs have narrow pitch electrode finger sections and an electrode finger pitch of the narrow pitch electrode finger section is set smaller than an electrode finger pitch of a main electrode finger section of the IDT provided with narrow pitch electrode fingers, and a phase of the first IDT is reversed by 180 degrees with respect to a phase of the third IDT, and the electrode finger pitch of any narrow pitch electrode finger section of the second IDT connected to the unbalanced terminal being set as P1, the number of electrode fingers of the narrow pitch electrode finger section thereof being set as N1, the electrode finger pitch of any narrow pitch electrode finger section of the first and third IDTs connected to the first and second balanced terminals being set as P2, and the number of electrode fingers of the narrow pitch electrode finger section thereof being set as N2, so that the following relations:

$$P1 \neq P2;$$

and

$$N1 < N2$$

are satisfied.

A ninth aspect of the invention is a balanced-type surface acoustic wave filter connected to an unbalanced terminal and first and second balanced terminals and provided with a balance-unbalance conversion function, including: a piezoelectric substrate; and first to third IDTs arranged on the piezoelectric substrate in a surface acoustic wave propagating direction, the balanced-type surface acoustic wave filter being characterized in that the first and third IDTs located on both sides in the surface acoustic wave propagating direction are connected to the unbalanced terminal, the second IDT includes first and second IDT sections divided in the surface acoustic wave propagating direction and the first and second IDT sections are respectively electrically connected to the first and second balanced signal terminals, the first to third IDTs are constructed to set a phase of a signal emanating from the unbalanced terminal to the first balanced signal terminal reversed by 180 degrees with respect to a phase of a signal emanating from the unbalanced terminal to the second balanced signal terminal, and in an area where the first to third IDTs are adjacent to one another in the surface acoustic wave propagating direction with a gap interposed therebetween, the respective IDTs have narrow pitch electrode finger sections at areas near the gap, and the electrode finger pitch of any narrow pitch electrode finger section of the first and third IDTs connected to the unbalanced signal terminal being set as P1, the number of electrode fingers of any narrow pitch electrode finger section thereof being set as N1, the electrode finger pitch of any narrow pitch electrode finger section of the second IDT whose first and second IDT sections are respectively connected to the first and second balanced signal terminal being set as P2, and the number of electrode fingers of the narrow pitch electrode finger section thereof being set as N2, so that the following relations:

$$P1 \neq P2;$$

and

$$N1 < N2$$

are satisfied.

In the seventh to ninth aspects of the invention, preferably, P1<P2 is satisfied.

The balanced-type surface acoustic wave filters according to the first and second aspects of the invention are provided with the first and second surface acoustic wave filter sections in which the second IDT in the center or the first and third IDTs on both the sides are connected to the unbalanced terminal, the first and third IDTs or the second IDT of the first surface acoustic wave filter section are/is connected to the first balanced terminal and the first and third IDTs or the second IDT of the second surface acoustic wave filter section are/is connected to the balanced terminal, and the phases of the output signals of the first and second surface acoustic wave filter sections are constructed to be different by 180 degrees. Therefore, the balanced-type surface acoustic wave filter provided with the balance-unbalance conversion function is constructed.

Then, in the first and second surface acoustic wave filter sections, the pair of IDTs adjacent to each other with a gap interposed therebetween has a narrow pitch electrode finger section where the pitch of a portion of the electrode fingers including an electrode finger facing the gap is smaller than the pitch of the electrode fingers of a main part of the IDT. Then, as P1>P2 and 1.12 K1/K2 1.65 are satisfied, it is possible to obtain the surface acoustic wave filter in which the insertion loss and the VSWR in the pass band are small, and not only a filter characteristic having sufficient bandwidth can be obtained but also the impedance ratio between the unbalanced signal terminal and the balanced signal terminal can be set to 1:2 with certainty. In particular, as it is possible to change the impedance ratio not only by adjusting the number of electrode fingers of the IDT but also by adjusting the pitch ratio of the narrow pitch electrode finger section, the impedance ratio between the unbalanced signal terminal and the balanced signal terminal can be set to 1:2 with precision.

In particular, according to the second aspect of the invention, as K1n=K2n is satisfied, the setting of the narrow pitch electrode finger section is facilitated, and at the same time the effect of suppressing the discontinuity in the area where the IDTs are adjacent can be further enhanced.

In the first and second aspects of the invention, when 67.4 $\lambda l \leq W/d \leq 74.3 \lambda l$ is satisfied, it is possible to set the impedance of the unbalanced terminal to 50 $\Omega$ and the impedance of the balanced terminal to 100 $\Omega$ with precision, and the balanced-type surface acoustic wave filter connected to the IC of the input impedance of 100 $\Omega$ can be easily provided.

In the balanced-type surface acoustic wave filters according to the third and fourth aspects of the invention, as the second IDT is connected to the unbalanced terminal, the first and third IDTs on both the sides are connected to the first and second balanced terminals, and the phase of the first IDT is reversed by 180 degrees with respect to the phase of the third IDT, similarly to the first aspect of the invention, the balanced-type surface acoustic wave filter provided with the balance-unbalance conversion function is constructed. Then, the first to third IDTs have the narrow pitch electrode finger sections, and P1>P2 and 1.12$\leq$K1/K2$\leq$1.65 are satisfied, and therefore it is possible to obtain the surface acoustic wave filter for making it possible that the insertion loss and the VSWR in the pass band are small, and not only the filter characteristic having the sufficient band width can be obtained but also the impedance ratio between the unbalanced signal terminal and the balanced signal terminal is set to 1:2 with reliability. In particular, as it is possible to change the impedance ratio not only by adjusting the number of electrode fingers of the IDT but also by adjusting the pitch ratio of the narrow pitch electrode finger section, the impedance ratio between the unbalanced signal terminal and the balanced signal terminal is set to 1:2 with precision.

In particular, according to the fourth aspect of the invention, K1n=K2n is satisfied, and therefore the designing of the IDT having the narrow pitch electrode finger section is facilitated, and at the same time the effect of suppressing the discontinuity of the area where the IDTs are adjacent due to the provision of the narrow pitch electrode finger section can be enhanced.

In the third and fourth aspects of the invention, when 134.8 $\lambda l \leq W/d \leq 148.6 \lambda l$ is satisfied, it is possible to set the impedance of the unbalanced terminal to 50 $\Omega$ and the impedance of the balanced terminal to 100 $\Omega$ with precision, making it possible to easily provide the balanced-type surface acoustic wave filter connected to the IC of the input impedance of 100 $\Omega$.

According to the fifth and sixth aspects of the invention, as the first to third IDTs are arranged in the surface acoustic wave propagating direction on the piezoelectric substrate, the first and third IDTs are connected to the unbalanced terminal, the second IDT includes the first and second IDT sections divided in the surface acoustic wave propagating direction, the first and second IDT sections are respectively connected to the first and second balanced signal terminals, and the phase of the signal from the unbalanced terminal to the first balanced terminal is reversed by 180 degrees with respect to the phase of the signal from the unbalanced terminal to the second balanced terminal, similarly to the first and second aspects of the invention, the balanced-type surface acoustic wave filter provided with the balance-unbalance conversion function is constructed.

Then, in the third aspect of the invention as well, the first to third IDTs have the narrow pitch electrode finger section, P1>P2 and 1.12$\leq$K1/K2$\leq$1.65 are satisfied, and therefore it is possible to obtain the surface acoustic wave filter for making it possible that the insertion loss and the VSWR in the pass band are small, and not only the sufficient filter characteristic having the sufficient band width can be obtained, but also the impedance ratio between the unbalanced signal terminal and the balanced signal terminal is set to 1:2. In particular, as it is possible to change the impedance ratio not only by adjusting the number of electrode fingers of the IDT but also by adjusting the pitch ratio of the narrow pitch electrode finger section, the impedance ratio between the unbalanced signal terminal and the balanced signal terminal can be set to 1:2 with precision.

In particular, according to the sixth aspect of the invention, K1n=K2n is satisfied, and therefore the designing of the IDT having the narrow pitch electrode finger section is facilitated, and at the same time the effect of the provision of the narrow pitch electrode finger section N, namely, the effect of suppressing the discontinuity of the area where the IDTs are adjacent can be further enhanced.

In the fifth and sixth aspects of the invention, when 134.8 $\lambda l \leq W/d \leq 148.6 \lambda l$ is satisfied it is possible to set the impedance of the unbalanced terminal to 50 $\Omega$ the impedance of the balanced terminal to 100 $\Omega$ with precision, and the balanced-type surface acoustic wave filter connected to the IC of the input impedance of 100 Ω can be provided easily.

According to the seventh aspect of the invention, the first and second surface acoustic wave filter sections including the first to third IDTs on the piezoelectric substrate are provided, the second IDT in the center, or the first and third IDTs on both the sides, of the first and second surface acoustic wave filter sections are connected to the unbalanced signal terminal and the first and third IDTs, or the second IDT, of the first surface acoustic wave filter section is connected to the first balanced signal terminal, the first and third IDTs, or the second IDT, of the second surface acoustic wave filter section are/is connected to the second balanced signal terminal, and the pair of IDTs adjacent in the surface acoustic wave propagating direction have a narrow pitch electrode finger section where the pitch of a portion of the electrode fingers including an electrode finger facing the gap is smaller than the pitch of the electrode fingers of a main part of the IDT. In the balanced-type surface acoustic wave filter provided with the balance-unbalance conversion function, $P1 \neq P2$ and $N1<N2$ are satisfied, and therefore it is possible to increase the degree of freedom for adjusting impedances of the respective resonant modes. Therefore, the impedance ratio between the unbalanced signal terminal and the balanced signal terminal can be set to 1:2 easily without degrading the film characteristic.

Thus, it is possible to obtain the surface acoustic wave for making it possible that the insertion loss and the VSWR in the pass band are small and not only the sufficient filter characteristic having the sufficient band width can be obtained but also the impedance ratio between the unbalanced signal terminal and the balanced signal terminal can be set to 1:2.

In particular, it is possible to change the impedance ratio not only by adjusting the number of electrode fingers of the IDT but also by adjusting the pitch ratio of the narrow pitch electrode finger section, and the impedance ratio between the unbalanced signal terminal and the balanced signal terminal can be set to 1:2.

According to the eighth aspect of the invention, in the balanced-type surface acoustic wave filter provided with the balance-unbalance conversion function in which the first to third IDTs are arranged on the piezoelectric substrate, the second IDT is connected to the unbalanced signal terminal, the first and third IDTs on both sides are connected to the first and second balanced signal terminals, and the first to third IDTs have the narrow pitch electrode finger section, $PI*P2$ and $N1<N2$ are satisfied, and therefore it is possible to obtain the surface acoustic wave for which the insertion loss and the VSWR in the pass band are small and not only a sufficient filter characteristic having sufficient bandwidth can be obtained but also the insertion loss and the VSWR in the pass band are small.

In particular, it is possible to change the impedance ratio not only by adjusting the number of electrode fingers of the IDT but also by adjusting the pitch ratio of the narrow pitch electrode finger section, and the impedance ratio between the unbalanced signal terminal and the balanced signal terminal can be set to 1:2.

According to the ninth aspect of the invention, in the balanced-type surface acoustic wave filter provided with the balance-unbalance conversion function in which the first to third IDTs are arranged in the surface acoustic wave propagating direction on the piezoelectric substrate, the first and third IDTs are connected to the unbalanced signal terminal, the second IDT is divided into the first and second IDT sections, the first and second IDT sections are respectively connected to the first and second balanced signal terminals, and the first to third IDTs have the narrow pitch electrode finger section, $P1 \neq P2$ and $N1<N2$ are satisfied, and therefore it is possible to obtain the surface acoustic wave for making it possible that the insertion loss and the VSWR in the pass band are small and not only the sufficient filter characteristic having the sufficient band width can be obtained but also the impedance ratio between the unbalanced signal terminal and the balanced signal terminal can be set to 1:2.

In particular, as it is possible to change the impedance ratio not only by adjusting the number of electrode fingers of the IDT but also by adjusting the pitch ratio of the narrow pitch electrode finger section, the impedance ratio between the unbalanced signal terminal and the balanced signal terminal can be set to 1:2 with precision.

In the seventh to ninth aspects of the invention, preferably, $P1<P2$ is satisfied, and in that case, the VSWR in the pass band can be further reduced, whereby it is possible to obtain even more satisfactory filter characteristics.

Brief Description of the Drawings

Fig. 1 is a schematic plan diagram showing an electrode construction of a balanced-type surface acoustic wave filter according to a first embodiment of the present invention.
Fig. 2 is a graph showing an attenuation-frequency characteristic of the surface acoustic wave filter according to the first embodiment.
Fig. 3 is a graph showing a VSWR characteristic of the surface acoustic wave filter according to the first embodiment.
Figs. 4(a) and 4(b) are Smith charts showing reflection characteristics of S11 and S22 of the surface acoustic wave filter according to the first embodiment.
Fig. 5 is a graph showing an attenuation-frequency characteristic of a narrow pitch electrode finger section of a surface acoustic wave filter in which electrode finger pitches are set equal to each other, prepared for comparison.
Fig. 6 is a graph showing a VSWR-frequency characteristic of the surface acoustic wave filter in which electrode finger pitches are set equal to each other, prepared for comparison.

Figs. 7(a) and 7(b) are Smith charts showing reflection characteristics of S11 and S22 of the surface acoustic wave filter in which electrode finger pitches are set equal to each other, prepared for comparison.

Figs. 8(a) and 8(b) are Smith charts showing reflection characteristics of S11 and S22 of a surface acoustic wave filter designed to set the impedance of the unbalanced signal terminal to 50 S2 and set the impedance of the balanced signal terminal to 150 S2.

Figs. 9(a) and 9(b) are Smith charts showing reflection characteristics of S11 and S22 obtained when the impedance of the unbalanced signal terminal is set to 50 S2 and the impedance of the balanced signal terminal is set to 100 S2.

Figs. 10(a) and 10(b) are Smith charts showing reflection characteristics on the S11 side and the S22 side obtained when the electrode finger cross width of the surface acoustic wave filter is changed to 51.0 λI.

Figs. 11 (a) and 11 (b) are Smith charts showing reflection characteristics on the S11 side and the S22 side obtained when the electrode fingers of the IDT are changed to set the impedance on the S11 side high and set the impedance of the S22 side low.

Figs. 12(a) and 12(b) are Smith charts showing reflection characteristics on the S11 side and the S22 side obtained when the electrode finger pitch of the narrow pitch electrode finger section of the IDT is changed from 0.444 λI to 0.438 λI.

Figs. 13(a) and 13(b) are Smith charts showing reflection characteristics on the S11 side and the S22 side obtained when the electrode finger pitch of the narrow pitch electrode finger section of the second IDT in the center is changed from 0.444 λI to 0.454 λI.

Fig. 14 is a graph for describing three resonant modes appearing in the balanced-type surface acoustic wave filter.

Figs. 15 are diagrams for describing an effective current distribution of each of the resonant modes shown in Fig. 14, in which Fig. 15(a) is a schematic construction diagram of the IDT and Fig. 15(b) is a graph showing each of the resonant modes corresponding to a position of the IDT.

Fig. 16 is a graph showing changes in the VSWR when the electrode finger cross width and the number of electrode fingers of the electrode finger section of the IDT are changed.

Fig. 17 is a graph showing an attenuation-frequency characteristic of the surface acoustic wave filter according to a second embodiment.

Fig. 18 is a graph showing the VSWR characteristic of the surface acoustic wave filter according to the second embodiment.

Figs. 19(a) and 19(b) are Smith charts showing reflection characteristics on the S11 side and the S22 side in the surface acoustic wave filter according to the second embodiment.

Figs. 20(a) and 20(b) are Smith charts showing reflection characteristics on the S11 side and the S22 side obtained when the number of electrode fingers connected to the balanced signal terminal of the narrow pitch electrode finger section in the surface acoustic wave filter according to the second embodiment is changed from three to five.

Fig. 21 is a schematic diagram showing a surface acoustic wave filter according to a third embodiment of the present invention.

Fig. 22 is a schematic diagram showing a surface acoustic wave filter according to a fourth embodiment of the present invention.

Fig. 23 is a schematic diagram showing a surface acoustic wave filter according to a fifth embodiment of the present invention.

Fig. 24 is a schematic diagram showing a surface acoustic wave filter according to a sixth embodiment of the present invention.

Fig. 25 is a schematic diagram showing a surface acoustic wave filter according to a seventh embodiment of the present invention.

Fig. 26 is a schematic diagram showing an example of a related-art balanced-type surface acoustic wave filter.

Fig. 27 is a schematic diagram showing another example of the related-art the balanced-type surface acoustic wave filter.

Reference Numerals

    1 balanced-type surface acoustic wave filter
    2 piezoelectric substrate
    3 unbalanced input terminal
    4 first longitudinally coupled resonator type surface acoustic wave filter section
    4a to 4c first to third IDTs
    4d and 4e reflectors
    5 second longitudinally coupled resonator type surface acoustic wave filter section
    5a to 5c first to third IDTs
    5d, 5e reflectors
    6 1 -port type surface acoustic wave resonator
    7 first balanced output terminal
    8 1 -port type surface acoustic wave resonator
    9 second balanced output terminal
    21 balanced-type surface acoustic wave filter
    22 piezoelectric substrate
    23 unbalanced input terminal
    24a to 24e IDTs
    24f, 24g reflectors
    25, 26 the first and second balanced signal terminals
    31 balanced-type surface acoustic wave filter

32 piezoelectric substrate

33 unbalanced input terminal

34, 35 surface acoustic wave filter sections

34a to 34e IDTs

34c1, 34c2 IDT division sections

34f, 34g reflectors

37 and 39 balanced output terminals

41 surface acoustic wave filter

42a to 42e IDTs

43 unbalanced input terminal

47 and 49 balanced output terminals

50, 51 surface acoustic wave filters

52a to 52e IDTs

52f and 52g reflectors

53 unbalanced input terminal

57, 59 balanced output terminals

70 surface acoustic wave filter section

N narrow pitch electrode finger section

Best Mode for Carrying Out the Invention

Hereinafter, with reference to the drawings, the present invention will be made apparent by describing specific embodiments of the present invention.

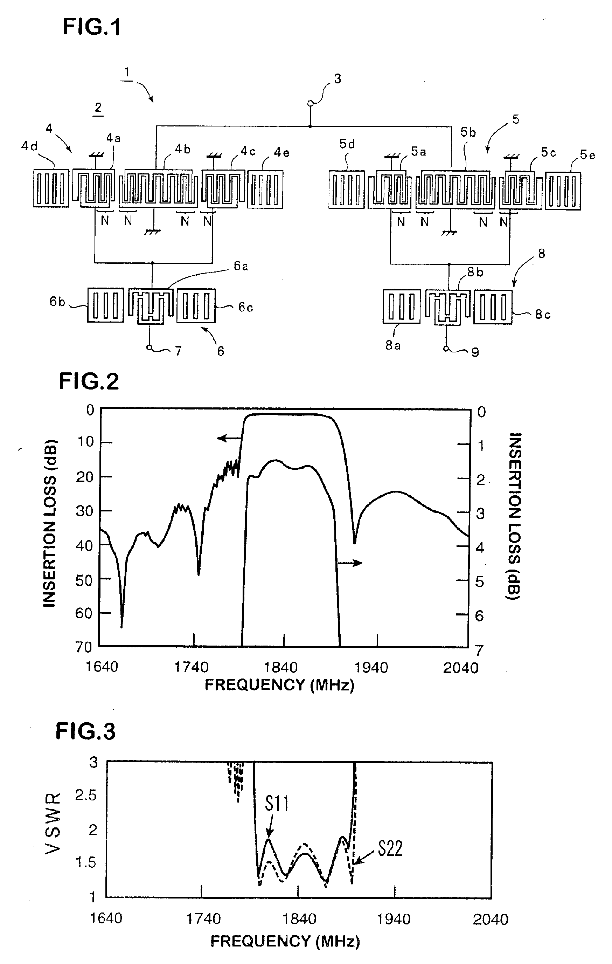

Fig. 1 is a schematic plan diagram showing an electrode construction of a balanced-type surface acoustic wave filter according to a first embodiment of the present invention.

In a balanced-type surface acoustic wave filter 1, an electrode construction as shown is formed on a piezoelectric substrate 2.

In the balanced-type surface acoustic wave filter 1, first and second longitudinally coupled resonator type surface acoustic wave filter sections 4 and 5 are connected to an unbalanced input terminal 3.

The first longitudinally coupled resonator type surface acoustic wave filter section 4 includes three IDTs 4a to 4c which are arranged along the surface acoustic wave propagating direction and reflectors 4d and 4e which are arranged on both sides, in the surface acoustic wave propagating direction, of the area where the IDTs 4a to 4c are arranged. The first to third IDTs 4a to 4c include narrow pitch electrode finger sections N. That is, by taking the IDTs 4a and 4b as an example, the IDTs 4a and 4b are adjacent with a gap interposed therebetween. The pitch of a plurality of electrode fingers including electrode fingers facing the gap in the IDTs 4a and 4b are made narrow as compared with an electrode finger pitch of the remaining main part electrode finger section of the IDTs 4a and 4b. An electrode finger section with this relatively small electrode finger pitch is a narrow pitch electrode finger section N.

in an area where the IDTs 4b and 4c are adjacent to each other as well, the IDTs 4b and 4c include the narrow pitch electrode finger sections N. With the provision of the narrow pitch electrode finger sections N, the discontinuity of the area where a pair of the IDTs are adjacent to each other with a gap interposed therebetween, and the gap between the IDTs, are adjusted, making it possible to obtain a band pass filter with a wider band width. The effect of the provision of such a narrow pitch electrode finger section is already known as described in, for example, Patent Document 4 described above.

The longitudinally coupled resonator type surface acoustic wave filter section 5 also includes the first to third IDTs 5a to 5c and the reflectors 5d and 5e similarly. Then, the IDTs 5a to 5c also include the narrow pitch electrode finger sections N.

The second IDTs 4b and 5b located in the center of the surface acoustic wave filter sections 4 and 5 are electrically connected to the unbalanced input terminal 3. The other ends of the IDTs 4b and 5b are connected to an earth potential.

In the surface acoustic wave filter section 4, the first and third IDTs 4a and 4c located on both sides of the second IDT 4b are electrically connected to a first balanced output terminal 7 via a 1-port type surface acoustic wave resonator 6.

In the same manner, in the surface acoustic wave filter section 5, the second IDT in the center 5b is connected to the unbalanced input terminal 3. The first and third IDTs 5a and 5c located on both sides of the IDT 5b are electrically connected to a second balanced output terminal 9 via a 1-port type surface acoustic wave resonator 8. The first longitudinally coupled resonator type surface acoustic wave filter section 4 and the second longitudinally coupled resonator type surface acoustic wave filter section 5 have all the same constructions except that the phase of the output signal is different by 180 degrees with respect to the input signal.

As described above, the IDTs 5a and 5c are inverted in phase by 180 degrees with respect to the IDTs 4a and 4c of the first surface acoustic wave filter section 4. Therefore, the signal emanating from the first balanced output terminal 7 and the signal emanating from the second balanced output terminal 9 are reversed in phase by 180 degrees. Thus, according to this embodiment, the balanced-type surface acoustic wave filter 1 including the unbalanced input terminal 3 and the first and second balanced output terminals 7 and 9 is constructed.

The 1-port type surface acoustic wave resonators 6 and 8 are constructed to have the same electrode construction.

The reason for the connection of the 1-port type surface acoustic wave resonator 6 is that the attenuation in the neighborhood of the pass band can be enlarged and steepness of the filter characteristic can be increased. Then, with the connection of the 1-port type surface acoustic wave resonators 6 and 8, it is possible to adjust the impedances of a plurality of resonant modes in the pass band, described below. In the meantime however, the surface acoustic wave resonators 6 and 8 may be not used.

It should be noted that the 1-port type surface acoustic wave resonators 6 and 8 may have a construction including no reflectors.

The electrode finger pitch of the narrow pitch electrode finger section N of the second IDT 4b and 5b in the first and second surface acoustic wave filter sections 4 and 5 is set to P1, and the electrode finger pitch of the narrow pitch electrode finger section N of the first and third IDTs 4a, 4c, 5a, and 5c is set to P2. Then, the number of electrode fingers of the electrode finger section except for the narrow pitch electrode finger section of the respective second IDTs 4b and 5b is set as K1 and the number of electrode fingers of the electrode finger section except for the narrow pitch electrode finger section of the first and third IDTs is set as K2. Furthermore, the number of electrode fingers of the narrow pitch electrode finger sections of the second IDTs 4b and 5b of the first and second surface acoustic wave sections 4 and 5 is set as K1n, and the number of electrode fingers of the narrow pitch electrode finger section of the first and third IDTs 4a, 4c, 5a, and 5c is set as K2n. The feature of this embodiment resides in the setting of P1>P2, K1n=K2n, and $1.12 \leq K1/K2 \leq 1.65$. Accordingly, not much influence is imparted on the filter characteristic, and it is possible to easily change the impedance ratio between the unbalanced input terminal 3 and the balanced output terminals 7 and 9. In particular, not only by adjusting the number of electrode fingers of the IDT but also by adjusting the pitch ratio of the narrow pitch electrode finger section N, the impedance ratio can be changed. Thus, the impedance ratio between the unbalanced signal terminal and the balanced signal terminal can be set, for example, to 1:2 with precision.

In particular, while the metallization ratio between the first and second surface acoustic wave sections 4 and 5 is set as d and an electrode finger cross width is set as W, in the case where 67.4 $\lambda$I$\leq$W/d$\leq$74.3 $\lambda$I (where $\lambda$I denotes a wavelength of the IDT) is satisfied, it is easy to set the impedance on the unbalanced input terminal 3 side to 50 $\Omega$ and the impedance on the sides of the balanced output terminals 7 and 9 to 100 $\Omega$ with requirement. This will be described in more detail with reference to specific examples.

It should be noted that, regarding the electrode construction of the drawings attached to this specification, for simplifying the graphic representation, the number of electrode fingers of the IDTs and the reflectors are represented with a smaller amount as compared with the number of actual electrode fingers.

The surface acoustic wave filter 1 is fabricated by the following specification.

An electrode finger cross width of the longitudinally coupled resonator type surface acoustic wave filter section is set to 51.0 $\lambda$I. $\lambda$ denotes an electrode finger pitch except for the narrow pitch electrode finger section of the IDT. In the IDTs 4a to 4c, the electrode finger cross widths are set equal to each other.

The number of electrode fingers of the IDT 4a is set to 22 (3), the number of electrode fingers of the IDT 4b is set to (3) 31 (3), and the number of electrode fingers of the IDT 4c is set to (3) 22. It should be noted that the number of electrode fingers in brackets represents the number of electrode fingers of one narrow pitch electrode finger section N and the number of electrode fingers outside the brackets represents the number of electrode fingers outside the narrow pitch electrode finger section N.

The number of electrode fingers of the respective reflectors 4d and 4e: 85. The metallization ratio in the IDTs 4a to 4c and the reflectors 4d and 4e: 0.72 except for the narrow pitch electrode finger section and 0.68 in the narrow pitch electrode finger section N.

The electrode film thickness=0.092 $\lambda$I.

It should be noted that the surface acoustic wave filter section 5 is designed in the same manner as above except that directions of the IDTs 5a and 5c are reversed with respect to those of the IDTs 4a and 4c.

Specification of the 1-port type surface acoustic wave resonator 6

The electrode finger cross width: 23.8 $\lambda$I (where $\lambda$I denotes a wavelength defined by the electrode finger pitch of the IDT 6a).

The number of electrode fingers of the IDT: 161.

The number of electrode fingers of the respective reflectors 6a and 6c: 15.

The metallization ratio: 0.60.

The electrode film thickness: 0.095 $\lambda$I.

It should be noted that a 40$\pm$5 degree Y-cut X-propagating LiTaO$_3$ substrate is used as the piezoelectric substrate 2 and the above-mentioned respective electrodes are formed of Al. In this manner, a DCS reception filter is formed with the unbalanced input terminal 3 having the input impedance of 50 $\Omega$ and the balanced output terminals 7 and 9 having the impedance of 100 $\Omega$.

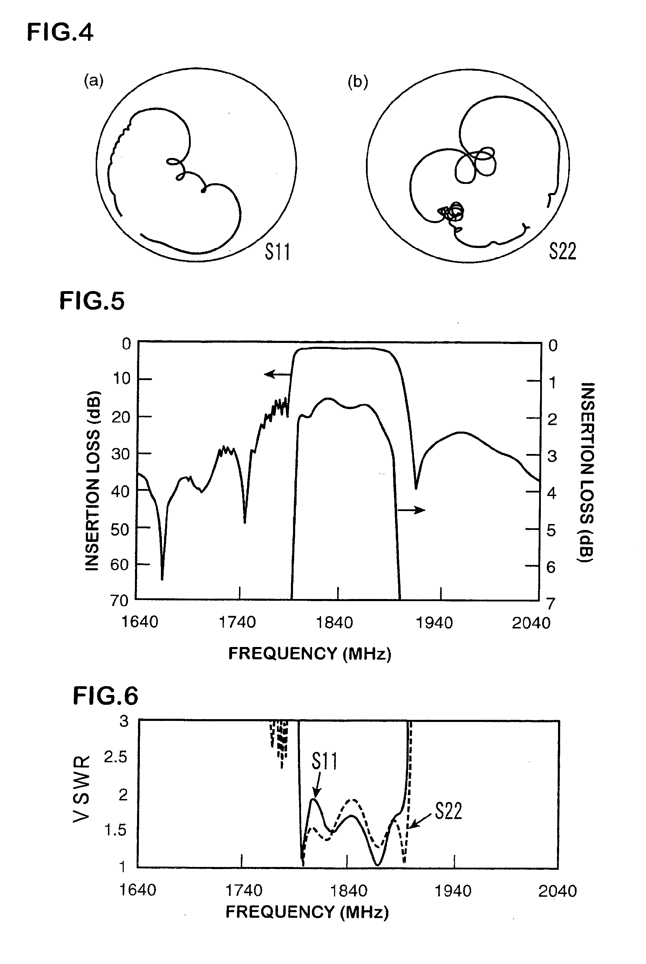

Characteristics of the surface acoustic wave filter 1 designed as described above are shown in Figs. 2 to 4. Fig. 2 shows an attenuation frequency characteristic of the surface acoustic wave filter 1. Then, Fig. 3 shows a VSWR characteristic of the surface acoustic wave filter 1. Fig. 4 (a) and (b) are Smith charts showing a reflection characteristic of S11 on the unbalanced signal terminal and a reflection characteristic of S22 on the balanced signal terminal. It should be noted that in the drawings attached to this specification, hereinafter, the reflection characteristic on the unbalanced signal terminal of the surface acoustic wave filter is set as S11 and the reflection characteristic on the balanced signal terminal is set as S22.

One feature of this embodiment resides in that an electrode finger pitch P1 of the narrow pitch electrode finger section N of the IDTs 4b and 5b connected to the unbalanced input terminal 3 and an electrode finger pitch P2 of the narrow pitch electrode finger section N of the IDTs 4a, 4c, 5a, and 5c connected to the balanced output terminals 7 and 9 are different from each other. That is, when a wavelength defined by the electrode finger pitch of the main part of the electrode finger section outside the narrow pitch electrode finger section N of the IDTs 4a to 4c and 5a to 5c is set as the electrode finger pitch P1 of the narrow pitch electrode finger section N of the second IDT 4b and 5b is set to 0.454 λI and the pitch P2 of the narrow pitch electrode finger section of the first and third IDTs 4a, 4c, 5a, and 5c is set to 0.438 λI. Therefore, the electrode finger pitch P1 of the narrow pitch electrode finger section N in the IDTs 4b and 5b connected to the unbalanced input terminal 3 is set larger than the electrode finger pitch of the narrow pitch electrode finger section P2 in the IDTs 4a, 4c, 5a, and 5c connected to the balanced output terminals 7 and 9.

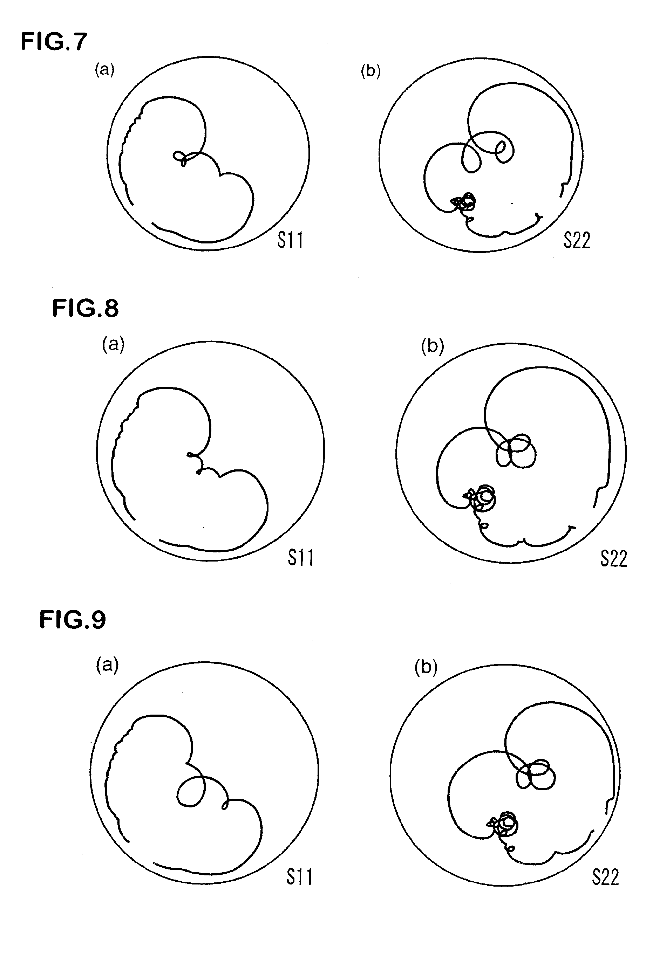

Figs. 5 to 7 show a filter characteristic of a balanced-type surface acoustic wave filter constructed similarly to the balanced-type surface acoustic wave filter 1 of the above-mentioned embodiment except that the electrode finger pitches of all of the narrow pitch electrode finger sections N are set equal to 0.447 λI for comparison. Fig. 5 shows an attenuation frequency characteristic of the above-mentioned surface acoustic wave filter prepared for comparison and Fig. 6 shows a VSWR characteristic. Figs. 7(a) and 7(b) show reflection characteristics S11 and S22, respectively.

It should be noted that the pass band for the DCS reception filter is 1805 to 1880 MHz. As is apparent from the comparison of Figs. 2 and 3 with Figs. 5 and 6, in the surface acoustic wave filter prepared for comparison, the above-mentioned maximum insertion loss in the pass band is 2.16 dB and the maximum value of the VSWR is 2.00, whereas in the surface acoustic wave filter 1 according to the above-mentioned embodiment, it is understood that the maximum insertion loss in the pass band is reduced to 2.13 dB and the maximum value of the VSWR in the pass band is also reduced to 1.83. Therefore, according to this embodiment, it is understood that the maximum insertion loss in the pass band can be improved by about 0.03 dB and also the VSWR can be improved by about 0.20.

In this embodiment, the reason why the insertion loss and the VSWR in the pass band can be improved in the above-mentioned manner will be described with reference to Figs. 8 to 13. First of all, Figs. 8(a) and 8(b) show the reflection characteristics S11 and S22 obtained when the surface acoustic wave filter is designed so that the impedance of the unbalanced input terminal 3 is set to 50 Ω and the balanced output terminals 7 and 9 is set to 150 Ω in the electrode construction shown in Fig. 1. Design parameters at this time are as follows.

The electrode finger cross width of the surface acoustic wave filter=41.7 λI.

The number of electrode fingers of the IDT 4a: 20 (3), the number of electrode fingers of the IDT 4b: (3) 33 (3), and the number of electrode fingers of the IDT 4c corresponds to (3) 20.

The number of electrode fingers of the reflectors: 85.

The metallization ratio: 0.72 (the metallization ratio of the narrow pitch electrode finger section is set to 0.68).

The electrode film thickness: 0.092 λI.

The electrode finger pitch of the narrow pitch electrode finger section N: 0.444 λI.

Figs. 9(a) and 9(b) show the reflection characteristics S11 and S22 obtained when reflection characteristics of the surface acoustic wave filter designed as described above are considered in which the impedance of the unbalanced input terminal is set to 50 Ω and the impedance of the balanced output terminals is set to 100 Ω. As is apparent from Figs. 9, the impedance of the S22 side is largely shifted from 100 Ω, which is the matching point.

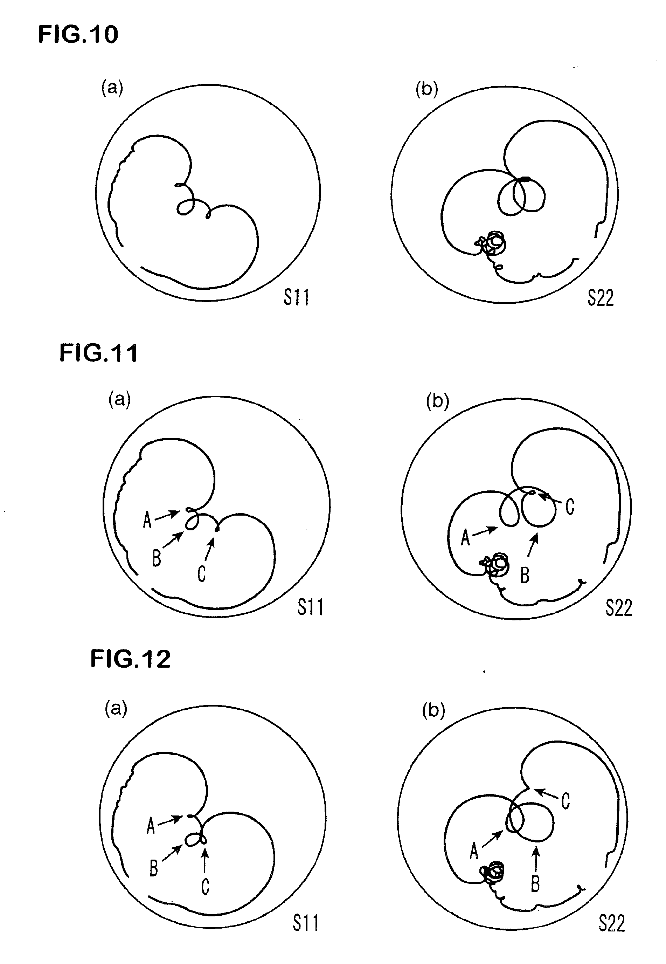

Next, Figs. 10(a) and 10(b) show characteristics obtained when the electrode finger cross width of the first and second longitudinally coupled resonator type surface acoustic wave filter sections 4 and 5 is changed from 41.7 λI to 751.0 λI in order to set the impedance of the S22 side to 100 Ω. At this time, the impedance of the S22 side is about 100 Ω. However, the impedance on the S11 side is largely shifted from 50 Ω, which is the matching point.

Next, in order that the impedance on the S11 side is high and at the same time the impedance on the S22 side is low, the number of electrode fingers of the IDTs 4b and 5b is set low and the number of electrode fingers of the IDTs 4a, 4c, 5a, and 5c is set large. That is, the construction is changed from 20 (3)/(3) 33 (3)/(3) 20 to 22 (3)/(3) 31 (3)/(3) 22. Figs. 11 (a) and 11 (b) show the reflection characteristics of the surface acoustic wave filter thus changed. As is apparent from Fig. 11, in this case, among three resonances A to C forming the pass band of the longitudinally coupled resonator type surface acoustic wave filter section, the impedance of the resonance A is high on the S11 side as desired and low on the S22 side. However, it is understood that the impedances of the resonances B and C hardly change.

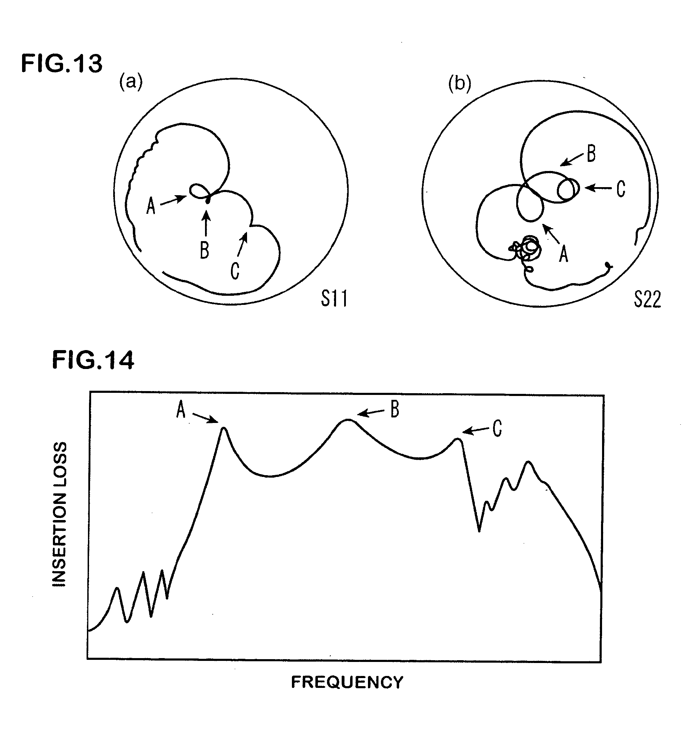

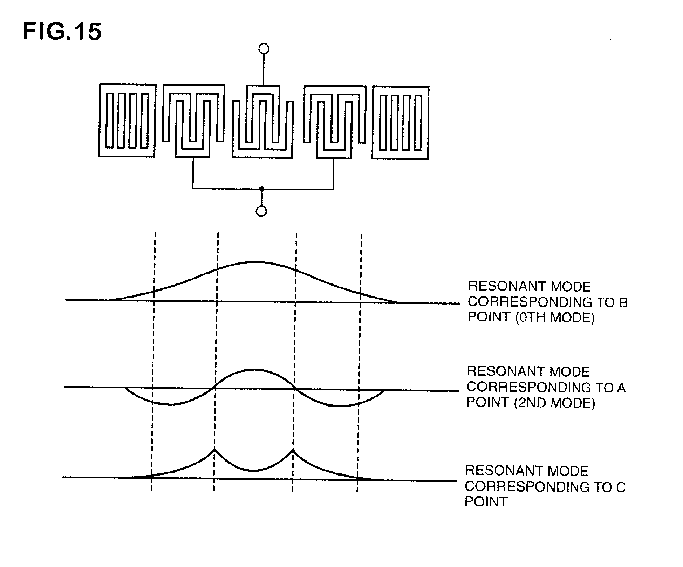

It should be noted that the above-mentioned resonances A to C refer to three resonances A to C constructing the pass band of the longitudinally coupled resonator type surface acoustic wave filter section as shown in Figs. 14 and 15. Here, the resonance A, the resonance B, and the resonance C appear in the ascending order of frequency, and as is apparent from Fig. 15, the resonance A is the 2nd mode resonance and the resonance B is the 0th mode resonance.

Next, with the constructions for obtaining the reflection characteristics S11 and S22 shown in Figs. 11 (a) and 11(b), Figs. 12(a) and 12(b) show characteristics obtained when the electrode finger pitch of the narrow pitch electrode finger section N of the IDTs 4a and 4c, and 5a and 5c is changed to 0.438 λI. That is, the electrode finger pitch of the narrow pitch electrode finger section is changed from 0.444 λI to 0.438 λI. As a result, as is apparent from Fig. 12(a), it is understood that a concentration ratio of the resonances A to C on the S11 side, that is, a concentration ratio of the impedance is improved. However, at the same time, it is understood that the impedance of the resonance B on the S11 side is too capacitative and furthermore that the resonance C on the S22 side is too inductive.

Next, with the constructions for obtaining the characteristics shown in Fig. 11, Figs. 13(a) and 13(b) show characteristics obtained when the electrode finger pitch of the narrow pitch electrode finger section N of the IDTs 4b and 5b is changed to 0.454 λI. That is, Figs. 13(a) and 13(b) show characteristics obtained when the electrode finger pitch of the narrow pitch electrode finger section N is changed from 0.444 λI to 0.454 λI. In this case, in contrast to the case where the electrode finger pitch of the narrow pitch electrode finger section P2 of the IDTs 4a and 4c, and 5a and 5c is set small, although the concentration ratio of the impedance on the S11 side is degraded, such a change occurs that the impedance of the resonance B on the S11 side is inductive and that of the resonance C on the S22 side is capacitative, that is, it is understood that when the electrode finger pitch P2 of the narrow pitch electrode finger section N of the IDTs 4a, 4c, 5a, and 5c connected to the balanced output terminals 7 and 9 is set small, by setting the electrode finger pitch P1 of the narrow pitch electrode finger section N of the IDTs 4b and 5b large, the respective demerits are covered up. Therefore, with the provision of such a construction, in the balanced-type surface acoustic wave filter according to the first embodiment described above, as shown in Figs. 4(a) and (b), it is understood that while the impedance ratio between the impedance of the balanced input terminal 3 and the balanced output terminals 7 and 9 is adjusted, the degradation in the filter characteristic can be suppressed.

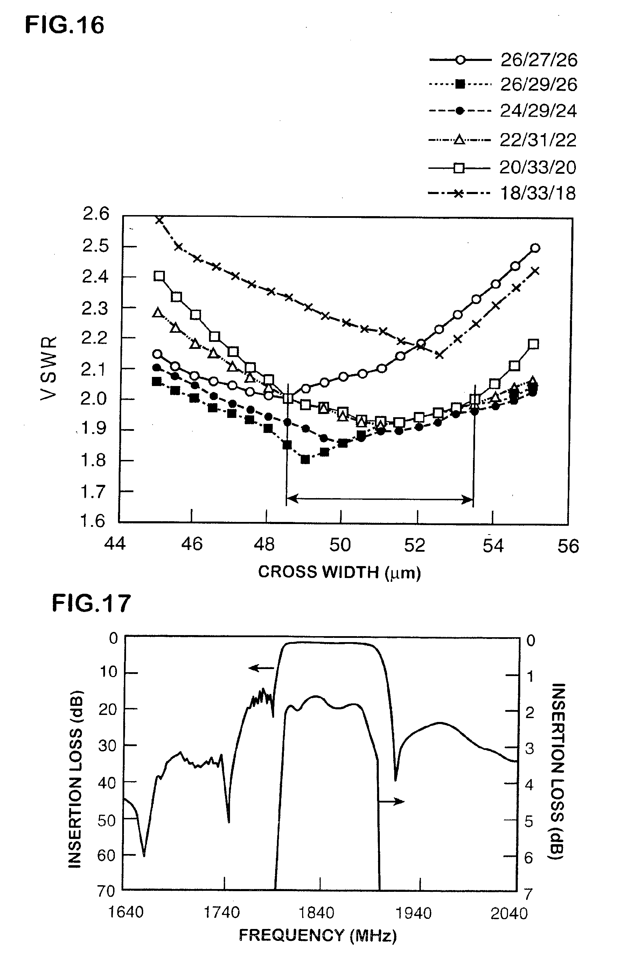

Next, in the surface acoustic wave filter 1 constructed to satisfy P1>P2, when the impedance ratio between the unbalanced input terminal 3 and the balanced output terminals 7 and 9 is set to about 1:2, the number and the cross width of the electrode fingers of the IDT for obtaining a satisfactory electric characteristic are checked. The result is shown in Fig. 16.

That is, the number of electrode fingers of the IDTs except for the electrode fingers of the narrow pitch electrode finger section, for example, the IDTs 4a to 4c of the above-mentioned embodiment, corresponds to 22/31/22. The number of electrode fingers of the IDTs 4a to 4c except for the electrode fingers of the narrow pitch electrode finger section is changed and moreover the electrode finger cross width is changed to fabricate various types of the surface acoustic wave filter 1 for measuring the VSWR. It should be noted that the IDTs 5a to 5c are similar to the IDTs 4a to 4c.

As is apparent from Fig. 16, it is understood that the VSWR becomes smaller than the value of the VSWR of 2.0 in the related-art balanced-type surface acoustic wave filter and the range of the improvement is the following range. It should be noted that hereinafter K1 denotes the number of electrode fingers of the remaining electrode finger section (excluding the electrode fingers of the narrow pitch electrode finger section N) in the second IDTs 4b and 5b in the center and K2 denotes the number of electrode fingers of the remaining electrode finger section (excluding the electrode fingers of the narrow pitch electrode finger section N) in the first and third IDTs 4a, 4c, 5a, and 5c.

| IDT finger number | K1/K2 | Cross width W range |
|---|---|---|
| 26/29/26 | 1.12 | 46.0 to 54.0 λI |
| 24/29/24 | 1.21 | 46.5 to 54.5 λI |
| 22/31/22 | 1.41 | 48.5 to 54.5 λI |
| 20/33/20 | 1.65 | 48.5 to 53.5 λI |

That is, it is understood when P1>P2 and $1.12 \leq K1/K2 \leq 1.65$ are satisfied, and furthermore when the electrode finger cross width is set in the range of 48.5 $\lambda I \leq W \leq 53.5 \lambda I$, the satisfactory film characteristic can be obtained.

In the meantime however, as is already known, when the metallization ratio is changed, the capacity is changed, the optimal value of the electrode finger cross width is changed. Thus, when a metallization ratio of electrode fingers except for the narrow pitch electrode finger section N is set as d, it is desirable to set the value of the electrode finger cross width W in the range of 67.4 $\lambda I \leq W/D \leq 74.3 \lambda I$. In this manner, the balanced-type surface acoustic wave filter 1 connected to the IC with the input impedance of 100 Ω and provided with the satisfactory film characteristic can be easily provided in which the impedance of the unbalanced input terminal 3 can be set to 50 Ω and the impedances of the balanced output terminals 7 and 9 can be set to 100 Ω with precision.

In particular, in the above-mentioned embodiment, not only the number of the electrode fingers, but also the electrode finger pitches P1 and P2 of the narrow pitch electrode finger sections are changed, and therefore the impedance ratio between the impedance of the unbalanced input terminal 3 and the impedances of the balanced output terminals 7 and 9 can be set to 1:2 with precision.

It should be noted that although K1 n=K2n is satisfied in this embodiment, the number of electrode fingers K1n of the narrow pitch electrode finger section of the second IDT 4b and 5b connected to the unbalanced signal terminal should not necessarily be equal to the number of electrode fingers K2n of the narrow pitch electrode finger section of the first and third IDTs 4a, 4c, 5a, and 5c connected to the balanced signal terminal. In the meantime however, as described above, with the setting of K1n=K2n, it is put into a preferable condition where the designing of the IDT is facilitated and at the same time the effect provided by the narrow pitch electrode finger section of suppressing the discontinuity in the area where the IDTs are located adjacent can be further enhanced.

(Second Embodiment)

A balanced-type surface acoustic wave filter having the same electrode construction as the balanced-type surface acoustic wave filter 1 of the first embodiment is fabricated. It should be noted that the electrode construction is the same as that of the first embodiment, hereinafter, reference numerals of the respective components of the surface acoustic wave filter according to the second embodiment are the same as in the case of the surface acoustic wave filter 1 and the corresponding description of Fig. 1 is incorporated.

The construction of the surface acoustic wave filter according to the second embodiment is the same as that of the surface acoustic wave filter according to the first embodiment except for the following three points.

(1) The number of electrode fingers of the IDTs 4a to 4c and 5a to 5c: 22 (5)/(3) 31 (3)/(5) 22, where the number of electrode fingers in brackets represents the number of electrode fingers of one narrow pitch electrode finger section and the number of electrode fingers outside the brackets represents the number of electrode fingers of the IDT except for the narrow pitch electrode finger section. The number of electrode fingers of the IDTs 5a to 5c is set equal to that of the IDTs 4a to 4c.
(2) The pitch P1 of the narrow pitch electrode finger section N of the second IDT 4b and 5b=0.437 λI
(3) The electrode finger pitch P2 of the narrow pitch electrode finger section N of the first and third IDTs 4a, 4c, 5a, and 5c=0.462 λI

That is, the number of electrode fingers N2 of the narrow pitch electrode finger section N of the IDTs 4a and 4c, 5a, and 5c connected to the balanced output terminals 7 and 9 is set larger than the number of electrode fingers N1 of the narrow pitch electrode finger section N of the IDTs 4b and 5b connected to the unbalanced input terminal 3, and at the same time the electrode finger pitch P2 is set larger than the electrode finger pitch P1.

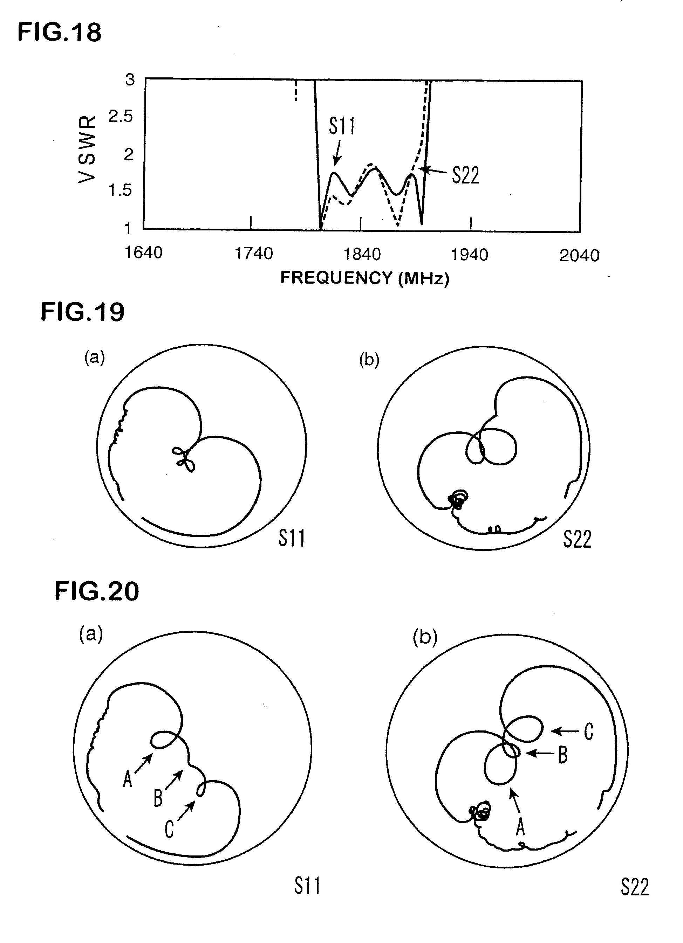

Figs. 17 and 18 show an attenuation frequency characteristic and a VSWR characteristic of the surface acoustic wave filter according to the second embodiment, and Figs. 19(a) and 19(b) are Smith charts showing a reflection characteristic on the S11 side and a reflection characteristic on the S22 side.

As is apparent from the comparison between Figs. 5 to 7 and Figs. 17 to 19, in the second embodiment, the maximum insertion loss in the pass band of the DCS reception filter is 1.96 dB and the maximum value of the VSWR is 1.90. Therefore, compared with the characteristics shown in Figs. 5 to 7 as the comparison example, according to the second embodiment, the maximum insertion loss in the pass band can be reduced to about 0.20 dB, and it is thus understood that the VSWR can be reduced by about 0.10 as well.

In the second embodiment, the reason why the filter characteristic is improved as compared with the above-mentioned comparison example is as follows. As is apparent from the reflection characteristics of Figs. 11 (a) and 11(b) used for explaining the principle of the above embodiments to be described below, in order that the impedance on the S11 side is set high, the impedance of the S22 side is set low, the number of electrode fingers of the IDT may be changed. From the reflection characteristics shown in Fig. 11, Figs. 20(a) and 20(b) show the reflection characteristics on the S11 side and the S22 side when the number of electrode fingers of the narrow pitch electrode finger section N connected to the balanced output terminals 7 and 9 is increased from 3 to 5. As is apparent from Figs. 20, with the change, it is understood that the resonance B is approaching the impedance matching point in the reflection characteristics on both the S11 side and the S22 side. That is, the impedance of the resonance B, which cannot be adjusted by only changing the number of electrode fingers of the IDT, can be adjusted by changing the number of electrode fingers of the narrow pitch electrode finger section N of the IDTs 4a, 4c, 5a, and 5c connected to the balanced output terminals 7 and 9. Then, eventually, the number of electrode fingers of the narrow pitch electrode finger sections N of the IDTs 4a to 4c and 5a to 5c respectively connected to the unbalanced input terminal 3 and the balanced output terminals 7 and 9 are optimized, thereby obtaining the characteristics of the second embodiment described above.

As described above, in the second embodiment, the second IDT of the longitudinally coupled resonator type surface acoustic wave filter sections 4 and 5 is connected to the unbalanced input terminal 3, the IDTs 4a and 4c, and 5a and 5c on both sides are respectively connected to the first and second balanced output terminals 7 and 9, whereby in the surface acoustic wave filter provided with a balance-unbalance conversion function, it is understood that with the construction for satisfying N1<N2 and P1<P2, it is possible to provide a surface acoustic wave filter in which not only the impedance ratio between the unbalanced input terminal 3 and the balanced output terminals 7 and 9 can be set to about 1:2 but also the insertion loss and the VSWR in the pass band are superior.

It should be noted that P1<P2 is satisfied in this embodiment, but if P1≠P2 is set, similarly to this embodiment, while ensuring the satisfactory film characteristic, the impedance ratio between the unbalanced input terminal 3 and the balanced output terminals 7 and 9 can be set about 1:2. In the meantime however, preferably, as described above, when P1<P2 is satisfied, the VSWR in the pass band can be made further smaller.

(Other Embodiments)

In the first and second embodiments, for the impedance adjustment, the method of setting the electrode finger pitch P1 of the second IDTs 4b and 5b connected to the unbalanced input terminal 3 different from the electrode finger pitch P2 of the narrow pitch electrode finger section N of the IDTs 4a and 4c, and 5a and 5c connected to the balanced output terminals 7 and 9, but another impedance adjustment method of setting the IDT duty ratio different for every IDT may be used in combination as well.

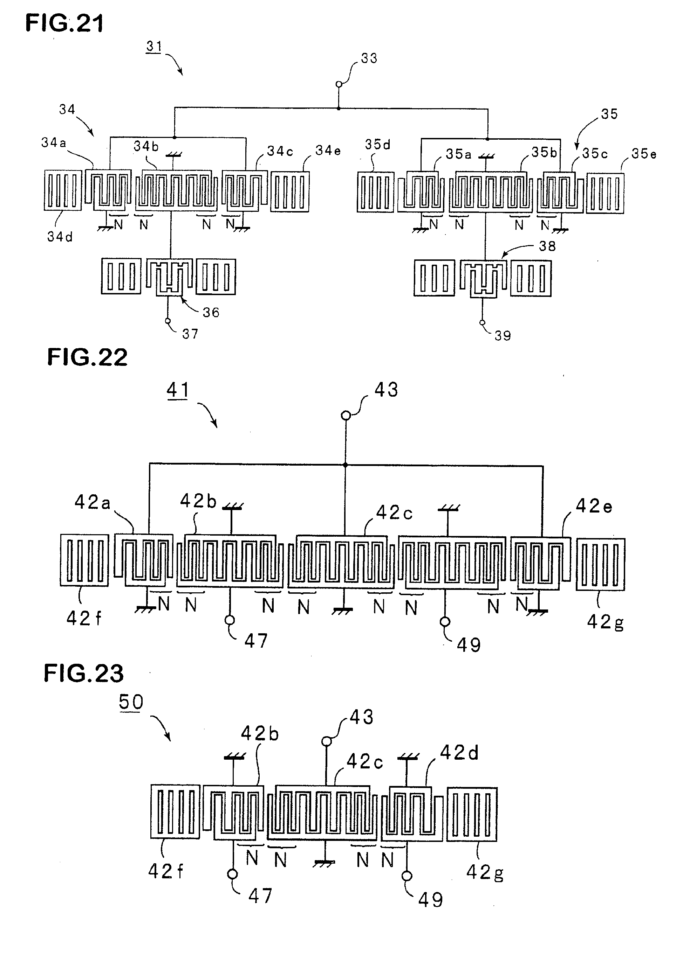

Then, in the first and second embodiments, the surface acoustic wave filter 1 provided with the balance-unbalance conversion function is constructed where three IDTs are provided, the second IDT 4b and 5b located in the center are connected to the unbalanced input terminal, and the IDTs 4a, 4c, 5a, and 5c located on the left and right sides are connected to the balanced output terminals 7 and 9. However, the present invention is not limited to the surface acoustic wave filter 1 provided with the balance-unbalance conversion function of such an electrode construction. Figs. 21 to 23 are schematic plan views showing an electrode construction of a surface acoustic wave filter according to the third to fifth embodiments of the present invention.

As shown in Fig. 21, in a balanced-type surface acoustic wave filter 31 of a third embodiment, the first and second longitudinally coupled resonator type surface acoustic wave filter sections 34 and 35 are connected to an unbalanced input terminal 33. The surface acoustic wave filter sections 34 and 35 are constructed similarly to the surface acoustic wave filter sections 4 and 5 of the surface acoustic wave filter 1 according to the first embodiment. In the meantime however, in the surface acoustic wave filter section 34, first and third IDTs 34a and 34c on both sides of the surface acoustic wave propagating direction are connected to an unbalanced input terminal 33. Then, a second IDT 34b located in the center is electrically connected to a first balanced output terminal 37 via a 1-port type surface acoustic wave resonator 36. Reflectors 34d and 34e are arranged on both sides, in the surface acoustic wave propagating direction, of the area where the IDTs 34a to 34c are provided. The 1-port type surface acoustic wave resonator 36 is constructed similarly to the 1-port type surface acoustic wave resonator 6.

In the surface acoustic wave filter section 35 as well, first and third IDTs 35a and 35c on both sides are connected to an unbalanced input terminal 33, a second IDT 35b is connected to a second balanced output terminal 39 via a 1-port type surface acoustic wave resonator 38. That is, in the surface acoustic wave filter 31, the first and third IDTs 34a, 34c, 35a and 35c in the surface acoustic wave propagating direction are electrically connected to the unbalanced input terminal 33 and the second IDTs in the center 34b and 35b are electrically connected to the first and second balanced output terminals 37 and 39.

In this case as well, as in the first embodiment, when the electrode finger pitch of the narrow pitch electrode finger section of the IDTs 34a, 34c, 35a and 35c connected to the unbalanced input terminal 33 is set as P1, an electrode finger pitch of the narrow pitch electrode finger section of the IDTs 34b and 35b connected to the balanced output terminals 37 and 39 is set as P2, the number of electrode fingers of the electrode finger section except for the narrow pitch electrode finger section of the IDTs 34a, 34c, 35a and 35c connected to the unbalanced input terminal 33 is set as K1, the number of electrode fingers of the narrow pitch electrode finger section thereof is set as K1n, the number of electrode fingers of the electrode finger section except for the narrow pitch electrode finger section of the IDTs 34b and 35b connected to the balanced output terminals 37 and 39 is set as K2, and the number of electrode fingers of the narrow pitch electrode finger section thereof is set as K2n, by setting of P1>P2 and $1.125 \leq K1/K2 \leq 1.65$, and then more preferably by setting of K1n=K2n, it is possible to provide the balanced-type surface acoustic wave filter in which the insertion loss and the VSWR in the pass band are small, the filter characteristic is satisfactory, and at the same time the impedance ratio between the unbalanced input terminal and the balanced output terminals 37 and 39 is set to about 1:2.

It should be noted that in the third embodiment as well, preferably, furthermore while the metallization ratio of the first and second surface acoustic wave filter sections 34 and 35 is set to d and an electrode finger cross width is set as W, in the case where 67.4 $\lambda l \leq W/d \leq 74.3 \lambda l$ is satisfied and therefore the impedance on the unbalanced input terminal 33 side is set to 50 $\Omega$, the output impedance on the side of the balanced output terminals 37 and 39 can be easily set to 100 $\Omega$.

Then, in the third embodiment too, as in the second embodiment, $P1 \neq P2$ is set, and preferably, P1<P2 is set. When the number of electrode fingers of the narrow pitch electrode finger section of the IDTs 34a, 34c, 35a and 35c connected to the unbalanced input terminal 33 is set as N1 and the number of electrode fingers of the narrow pitch electrode finger section of the IDTs connected to the first and second balanced output terminals 37 and 39 is set as N2, by setting N1<N2, the degree of freedom for adjusting impedances of a plurality of resonant modes can be increased. Therefore, the insertion loss and the VSWR in the pass band are small, and not only the satisfactory film characteristic is attained but also the impedance ratio between the unbalanced input terminal 33 and the balanced output terminals 37 and 39 can be set to 1:2.

Fig. 22 is a schematic plan view showing an electrode construction of a surface acoustic wave filter section 41 according to a fourth embodiment. In the balanced-type surface acoustic wave filter 41 of the fourth embodiment, five IDTs 42a to 42e are arranged along the surface acoustic wave propagating direction. Reflectors 42f and 42g are arranged on both sides, in the surface acoustic wave propagating direction, of an area where the IDTs 42a to 42e are arranged. The IDTs 42a to 42e include the narrow pitch electrode finger sections N similarly to the IDTs 4a to 4c. That is, in a pair of IDTs adjacent to each other in the surface acoustic wave propagating direction with a gap interposed therebetween, a pitch of electrode fingers of a part of electrode fingers including electrode fingers facing the gap is made smaller than an electrode finger pitch of the remaining IDTs.

In the surface acoustic wave filter section 41, the IDTs 42a, 42c, and 42e are connected to an unbalanced input terminal 43. Then, the IDTs 42b and 42d are respectively electrically connected to the first and second balanced output terminals 47 and 49. In the surface acoustic wave filter section 41 provided with such a balance-unbalance conversion function, when the electrode finger pitch of the narrow pitch electrode finger section N of the IDTs 42a, 42c, and 42e connected to the unbalanced input terminal 43 is set as P1, the number of electrode fingers of the narrow pitch electrode finger section N thereof is set as K1 n, the number of electrode fingers except for the narrow pitch electrode finger section thereof is set as K1, the electrode finger pitch of the narrow pitch electrode finger section N of the IDTs 42b and 42d connected to the balanced output terminals 47 and 49 is set as P2, the number of electrode fingers of the narrow pitch electrode finger section thereof is set as K2n, and the number of electrode fingers except for the narrow pitch electrode finger section thereof is set as K2, and by setting of P1>P2 and 1.12≤K1/K2≤1.65, and preferably, by further setting of K1 n=K2n, reduction in the insertion loss and the VSWR in the pass band is achieved and the impedance ratio between the unbalanced input terminal 43 and the balanced output terminals 47 and 49 can be set to about 1:2. Preferably, by setting of 134.8 λl≤W/d≤148.6 λl, when the impedance on the unbalanced input terminal 43 side is set to 50 Ω, the impedance on the side of the balanced output terminals 47 and 49 can be easily set to 100 Ω.

In the fourth embodiment too, as in the second embodiment, apart from the above, by also setting of P2>P1 and N2>N1, the impedance ratio between the unbalanced input terminal and the balanced output terminals can be set to 1:2 easily and at the same time the reduction in the insertion loss and the VSWR in the pass band can be achieved.

Fig. 23 is a schematic plan view showing an electrode construction of a balanced-type surface acoustic wave filter of a fifth embodiment. A surface acoustic wave filter 50 according to the fifth embodiment is constructed similarly to the surface acoustic wave filter 41 according to the fourth embodiment except that the number of the IDTs is three. That is, in a balanced-type surface acoustic wave filter 50 according to the fifth embodiment, three IDTs 42b to 42d are arranged along the surface acoustic wave propagating direction. Reflectors 42f and 42g are arranged on both sides, in the surface acoustic wave propagating direction, of an area where the first to third IDTs 42b to 42d are provided.

Therefore, except for the omission of IDTs 42a and 42e of Fig. 22, the surface acoustic wave filter 50 is constructed similarly to the surface acoustic wave filter 41. Therefore, the same reference numerals are given to the same components with the incorporation of the description with respect to Fig. 22.

In this embodiment as well, by setting of P1>P2 and 1.12≤K1/K2≤1.65, and preferably, by further setting of K1n=K2n, as in the case of the fourth embodiment, a reduction in the insertion loss and the VSWR in the pass band is achieved and the impedance ratio between the unbalanced input terminal 43 and the balanced output terminals 47 and 49 can be set to about 1:2. Then, preferably, by setting of 134.8 λl≤W/d≤148.6 λl, when the impedance on the unbalanced input terminal 43 side is set to 50 Ω, the impedance on the side of the balanced output terminals 47 and 49 can be easily set to 100 Ω.

In the fifth embodiment too, as in the second embodiment, apart from the above, by setting of N2>N1 and P2≠P1, and preferably by setting of N2>N1 and P2>P1 as well, the impedance ratio between the unbalanced input terminal and the balanced output terminals can be easily set to about 1:2 and at the same time a reduction in the insertion loss and the VSWR in the pass band can be achieved.

Fig. 24 is schematic plan view showing an electrode construction of a balanced-type surface acoustic wave filter of a sixth embodiment. In the balanced-type surface acoustic wave filter 51 according to the sixth embodiment, five IDTs 52a to 52e are arranged along the surface acoustic wave propagating direction. The IDTs 52a to 52e include the narrow pitch electrode finger sections N similarly to the IDTs 42a to 42e. Then, reflectors 52f and 52g are arranged on both sides, in the surface acoustic wave propagating direction, of an area where the IDTs 52a to 52e are provided. It should be noted that the IDT 52c in the center includes IDT sections 52c1 and 52c2 divided in the surface acoustic wave propagating direction.

In this embodiment, the IDTs 52b and 52d are electrically connected to an unbalanced input terminal 53. Then, IDT 52a and the IDT section 52c1 are electrically connected to a first balanced output terminal 57 and the IDT section 52c2 and the IDT 52e are electrically connected to a balanced output terminal 59, thereby realizing the balance-unbalance conversion function.

In this embodiment as well, when the electrode finger pitch of the narrow pitch electrode finger section N in the IDTs 52b and 52d connected to the unbalanced input terminal 53 is set as P1, the number of electrode fingers of the narrow pitch electrode finger section N thereof is set as K1 n, the number of electrode fingers of the electrode finger section except for the narrow pitch electrode finger section is set as K1, the electrode finger pitch of the narrow pitch electrode finger section N of the IDTs 52a, 52c, and 52e connected to the balanced output terminals 57 and 59 is set as P2, the number of electrode fingers of the narrow pitch electrode finger section thereof is set as K2n, the number of electrode fingers of the electrode finger section except for the narrow pitch electrode finger section is set as K2, P1>P2 and 1.12≤K1/K2≤1.65 are satisfied, and preferably, moreover K1n=K2 is satisfied, without degrading the filter characteristic similarly to the respective above-mentioned embodiments, the impedance ratio between the unbalanced signal terminal and the balanced signal terminal can be set to about 1:2. In the sixth embodiment as well, preferably, 134.8 λI≤W/d≤148.6 λI is satisfied, when the impedance connected to the unbalanced input terminal 53 side is set to 50 Ω, the impedance on the side of the balanced output terminals 57 and 59 can be easily set to 100 Ω.

Then, the sixth embodiment too, as in the second embodiment, P1≠P2 and N1<N2 are satisfied, and preferably, with the construction for satisfying P1<P2 and N1<N2, as in the second embodiment, it is possible to provide the surface acoustic wave filter in which the impedance ratio between the unbalanced input terminal 53 and the balanced output terminals 57 and 59 is about 1:2 and also the insertion loss and the VSWR are small in the pass band.

Fig. 25 is a schematic plan view showing an electrode construction of a balanced-type surface acoustic wave filter according to a seventh embodiment. A surface acoustic wave filter 70 according to the seventh embodiment has almost the same construction as the surface acoustic wave filter 51 according to the sixth embodiment shown in Fig. 24 except that the IDTs 52a and 52e are omitted. Therefore, the same reference numerals are given to the same components, and the description made with reference to the sixth embodiment is incorporated.

In this embodiment, the first to third IDTs 52b to 52d are arranged along the surface acoustic wave propagating direction. Then, the second IDT in the center 52c is divided to have the IDT sections 52c1 and 52c2. In this embodiment too, as in the case of the sixth embodiment, by satisfying P1>P2 and 1.12≤K1/K2≤1.65, and preferably, by further satisfying K1n=K2n, the impedance ratio between the unbalanced input terminal and the balanced output terminal can be set to about 1:2 without degrading the filter characteristic. In the seventh embodiment as well, preferably, by satisfying 134.8 λI≤W/d≤148.6 λI, when the impedance on the unbalanced input terminal 53 side is set to 50 Ω, it is possible to easily set the impedance on the side of the balanced output terminals 57 and 59 to 100 Ω.

Then, according to seventh embodiment too, as in the second embodiment, with the construction for satisfying P1≠P2 and N1<N2, and preferably, the construction for satisfying P1<P2 and N1<N2, it is possible to provide the surface acoustic wave filter in which the impedance ratio between the unbalanced input terminal 53 and the balanced output terminals 57 and 59 is set to about 1:2 and also the insertion loss and the VSWR are small in the pass band.

It should be noted that in the surface acoustic wave filters 41 and 51 according to the fourth and sixth embodiments, the five IDTs 42a to 42e and 52a to 52e are provided. In this manner, in the surface acoustic wave filters according to the present invention, not only the three IDTs composed of the first to third IDTs but also five or more IDTs may be arranged in the surface acoustic wave propagating direction.

## Claims

1. A balanced-type surface acoustic wave filter (1) connected to an unbalanced terminal (3) and first and second balanced terminals (7,9) and provided with a balance-unbalance conversion function, comprising:

    a piezoelectric substrate (2);
    a first surface acoustic wave filter section (4) including first to third IDTs (4a-4c) arranged along a surface acoustic wave propagating direction on the piezoelectric substrate, the second IDT (4b) in the center or the first and third IDTs (4a,4c) on both the sides being connected to the unbalanced terminal (3), and the first and third IDTs (4a,4c) on both sides or the second IDT (4b) in the center being connected to the first balanced terminal (7); and
    a second surface acoustic wave filter section (5) including first to third IDTs (5a-5c) arranged on the piezoelectric substrate in the surface acoustic wave propagating direction, the second IDT (5b) in the center or the first and third IDTs (5a,5c) on both sides being connected to the unbalanced terminal (3), the first and third IDTs (5a,5c) on both sides or the second IDT (5b) in the center being connected to the second balanced terminal (9), and the second surface acoustic wave filter section (5) being constructed to have a phase of an output signal to an input signal different by 180 degrees with respect to the first surface acoustic wave filter section (4), the balanced-type surface acoustic wave filter (1) being **characterized in that**:

    in the first and second surface acoustic wave filter sections (4,5), in a pair of IDTs (4a,4b;4b,4c;5a,5b;5b,5c) adjacent to each other with a gap interposed therebetween in the surface acoustic wave propagating direction, a section where the pitch of a portion of the electrode fingers including an electrode finger facing the gap is smaller than the pitch of the electrode fingers of a main part of the IDT is set as a narrow pitch electrode finger section (N); and
    the electrode finger pitch of the narrow pitch electrode finger section (N) of any IDT connected to the unbalanced terminal (3) of the first and second surface acoustic wave filter sections (4,5) being set as P1, the electrode finger pitch of any narrow pitch electrode finger section (N) of the IDT connected to the balanced terminal (7,9) being set as P2, the number of electrode fingers of the main electrode finger section outside the narrow pitch electrode finger section of any IDT connected to the unbalanced terminal (3) of the first and second surface acoustic wave filter sections (4,5) being set as K1, and the number of electrode fingers of the main electrode finger section outside the narrow pitch electrode finger section of any IDT connected to the balanced terminal (7,9) being set as K2, so that the following relations:

$$P1>P2;$$

and

$$1.12 \leq K1/K2 \leq 1.65$$

are satisfied.

2. A balanced-type surface acoustic wave filter (1) according to Claim 1, wherein when the number of electrode fingers of the narrow pitch electrode finger section (N) of the IDT connected to the unbalanced terminal (3) of the first and second surface acoustic wave filter sections (4,5) is set as K1n, and the number of electrode fingers of the narrow pitch electrode finger section (N) of the IDT connected to the balanced terminal (7,9) is set as K2n, the following relations:

$$P1>P2;$$

$$K1n=K2n;$$

and

$$1.12 \leq K1/K2 \leq 1.65$$

are satisfied.

3. The balanced-type surface acoustic wave filter (1) according to Claim 1 or 2, wherein when a metallization ratio in the first and second surface acoustic wave filter sections (4,5) is set as d and an electrode finger cross width is set as W, 67.4 $\lambda$I$\leq$W/d$\leq$74.3 $\lambda$I (where $\lambda$I denotes a wavelength of the IDT) is satisfied.

4. A balanced-type surface acoustic wave filter (41/50) connected to a balanced terminal (43) and first and second unbalanced terminals (47,49) and provided with a balance-unbalance conversion function, comprising:

a piezoelectric substrate; and
first to third IDTs (42b-42d) arranged on the piezoelectric substrate in a surface acoustic wave propagating direction, the balanced-type surface acoustic wave filter (41/50) being **characterized in that**:

the second IDT (42c) is connected to the unbalanced terminal (43) and the first and third IDTs (42b,42d) on both sides are respectively connected to the first and second balanced terminals (47,49);
that in an area where the first to third IDTs (42b-42d) are adjacent one another, the respective IDTs have narrow pitch electrode finger sections (N) and an electrode finger pitch of the narrow pitch electrode finger section (N) is set smaller than an electrode finger pitch of a main electrode finger section of the IDT provided with narrow pitch electrode fingers;
that a phase of the first IDT (42b) is reversed by 180 degrees with respect to a phase of the third IDT (42d); and
the electrode finger pitch of any narrow pitch electrode finger section (N) of the second IDT (42c) located in the center being set as P1, the electrode finger pitch of any narrow pitch electrode finger section (N) of the first and third IDTs (42b,42d) being set as P2, the number of electrode fingers of the main electrode finger section outside the narrow pitch electrode finger section of the second IDT (42c) being set as K1, and the number of electrode fingers of the main electrode finger section outside the narrow pitch electrode finger section of the first and third IDTs (42b,42d) being set as K2, so that the following relations:

$$P1>P2;$$

and

$$1.12 \leq K1/K2 \leq 1.65$$

are satisfied.

5. A balanced-type surface acoustic wave filter (41/50) according to claim 4, wherein when the number of electrode fingers of the narrow pitch electrode finger section (N) of the second IDT (42c) is set as K1n, and the number of electrode fingers of the narrow pitch electrode finger section (N) of the first and third IDTs (42b,42d) is set as K2n, the following relations:

$$P1>P2;$$

$$K1n=K2n;$$

and

$$1.12 \leq K1/K2 \leq 1.65$$

are satisfied.

6. The balanced-type surface acoustic wave filter (41/50) according to Claim 4 or 5, wherein when a metallization ratio in the first to third IDTs (42b-42d) is set as d and an electrode finger cross width is set as W, $134.8\,\lambda l \leq W/d \leq 148.6\,\lambda l$ (where $\lambda l$ denotes a wavelength of the IDT) is satisfied.

7. A balanced-type surface acoustic wave filter (51/70) connected to an unbalanced terminal (53) and first and second balanced terminals (57,59) and provided with a balance-unbalance conversion function, comprising:

a piezoelectric substrate; and
first to third IDTs (52b-52d) arranged on the piezoelectric substrate in a surface acoustic wave propagating direction, the balanced-type surface acoustic wave filter being **characterized in that**:

the first and third IDTs (52b,52d) located on both sides in the surface acoustic wave propagating direction are connected to the unbalanced terminal (53);
the second IDT (52c) includes first and second IDT sections (52c1,52c2) divided in the surface acoustic wave propagating direction, the first and second IDT sections (52c1,52c2) are respectively electrically connected to the first and second balanced signal terminals (57,59), and the first to third IDTs (52b-52d) are constructed to set a phase of a signal emanating from the unbalanced terminal (53) to the first balanced signal terminal (57) reversed by 180 degrees with respect to a phase of a signal emanating from the unbalanced terminal (53) to the second balanced signal terminal (59);

in an area where the first to third IDTs (52b-52d) are adjacent one another in the surface acoustic wave propagating direction with a gap interposed therebetween, a plurality of electrode fingers near the gap correspond to a narrow pitch electrode finger section (N) where a pitch of the electrode fingers is relatively small; and
the electrode finger pitch of the narrow pitch electrode finger section (N) of the first and third IDTs (52b,52d) connected to the unbalanced signal terminal (53) being set as P1, the electrode finger pitch of any narrow pitch electrode finger section (N) of the second IDT (52c) whose first and second IDT sections (52c1,52c2) are respectively connected to the first and second balanced signal terminal (57,59) being set as P2, the number of electrode fingers of the main electrode finger section outside the narrow pitch electrode finger section of the first and third IDTs (52b,52d) being set as K1, and the number of electrode fingers of the main electrode finger section outside the narrow pitch electrode finger section of the second IDT (52c) being set as K2, so that the following relations:

$$P1>P2;$$

and

$$1.12 \leq K1/K2 \leq 1.65$$

are satisfied.

8. A balanced-type surface acoustic wave filter (51/70) according to claim 7, wherein when the number of electrode fingers of the narrow pitch electrode finger section (N) of the first and third IDTs (52b,52d) is set as K1n, and the number of electrode fingers of the narrow pitch electrode finger section (N) of the second IDT (52c) is set as K2n, the following relations:

$$P1>P2;$$

$$K1n=K2n;$$

and

$$1.12 \leq K1/K2 \leq 1.65$$

are satisfied.

9. The balanced-type surface acoustic wave filter (51/70) according to Claim 7 or 8, wherein when a metallization in the first to third IDTs is set as d and an electrode finger cross width is set as W, 134.8 $\lambda I \leq W/d \leq 148.6 \lambda I$ (where $\lambda I$ denotes a wavelength of the IDT) is satisfied.

10. A balanced-type surface acoustic wave filter connected to an unbalanced terminal (3) and first and second balanced terminals (7,9) and provided with a balance-unbalance conversion function, comprising:

a piezoelectric substrate (2);
a first surface acoustic wave filter section (4) including first to third IDTs (4a-4c) arranged on the piezoelectric substrate along a surface acoustic wave propagating direction, the second IDT (4b) in the center or the first and third IDTs (4a,4c) on both sides being connected to the unbalanced terminal (3), and the first and third IDTs (4a,4c) on both sides or the second IDT (4b) in the center being connected to the first balanced terminal (7); and
a second surface acoustic wave filter section (5) including first to third IDTs (5a-5c) arranged on the piezoelectric substrate in the surface acoustic wave propagating direction, the second IDT (5b) in the center or the first and third IDTs (5a,5c) on both sides being connected to the unbalanced terminal (3), the first and third IDTs (5a,5c) on both sides or the second IDT (5b) in the center being connected to the second balanced terminal (9), and the second surface acoustic wave filter section (5) being constructed to have a phase of an output signal to an input signal different by 180 degrees with respect to the first surface acoustic wave filter section (4), the balanced-type surface acoustic wave filter being **characterized in that**:

in the first and second surface acoustic wave filter sections (4,5), in a pair of IDTs (4a,4b;4b,4c;5a,5b;5b,5c) adjacent to each other with a gap interposed therebetween in the surface acoustic wave propagating direction, a section where the pitch of a portion of the electrode fingers including an electrode finger facing the gap is smaller than the pitch of electrode fingers of a main part of the IDT is set as a narrow pitch electrode finger section (N); and
the electrode finger pitch of the narrow pitch electrode finger section (N) of any IDT connected to the unbalanced terminal (3) of the first and second surface acoustic wave filter sections (4,5) being set as P1, the number of electrode fingers of the narrow pitch electrode finger section (N) thereof being set as N1, the electrode finger pitch of the narrow pitch electrode finger section (N) of the IDT connected to the first and second balanced terminals (7,9) being set as P2, and the number of electrode fingers of the narrow pitch electrode finger section (N) thereof being set as N2, so that the following relations:

$$P1 \neq P2;$$

and

$$N1 < N2$$

are satisfied.

11. The balanced-type surface acoustic wave filter according to Claim 10, **characterized in that** P1<P2 is satisfied.

12. A balanced-type surface acoustic wave filter connected to a balanced terminal (43) and first and second unbalanced terminals (47,49) and provided with a balance-unbalance conversion function, comprising:

a piezoelectric substrate; and
first to third IDTs (42b-42d) arranged on the piezoelectric substrate in a surface acoustic wave propagating direction, the balanced-type surface acoustic wave filter being **characterized in that**:

the second IDT (42c) is connected to the unbalanced terminal (43) and the first and third IDTs (42b,42d) are respectively connected to the first and second balanced terminals (47,49);
in an area where the first to third IDTs (42b-42d) are adjacent one another, the respective IDTs have narrow pitch electrode finger sections (N) and an electrode finger pitch of the narrow pitch electrode finger section (N) is set smaller than an electrode finger pitch of a main electrode finger section of the IDT provided with narrow pitch electrode fingers;
the phase of the first IDT (42b) is reversed by 180 degrees with respect to the phase of the third IDT (42d); and
the electrode finger pitch of any narrow pitch electrode finger section (N) of the second IDT (42c) connected to the unbalanced terminal (43) being set as P1, the number of electrode fingers of the narrow pitch electrode finger section (N) thereof being set as N1, the electrode finger pitch of any narrow pitch electrode finger section (N) of the first and third IDTs (42b,42d) connected to the first and second balanced terminals (47,49) being set as P2, and the number of electrode fingers of the narrow pitch electrode finger section (N) thereof being set as N2, so that the following relations:

$$P1 \neq P2;$$

and

$$N1 < N2$$

are satisfied.

13. The balanced-type surface acoustic wave filter according to Claim 12, **characterized in that** P1<P2 is satisfied.

14. A balanced-type surface acoustic wave filter connected to an unbalanced terminal (53) and first and second balanced terminals (57,59) and provided with a balance-unbalance conversion function, comprising:

a piezoelectric substrate; and
first to third IDTs (52b-52d) arranged on the piezoelectric substrate in a surface acoustic wave propagating direction, the balanced-type surface acoustic wave filter being **characterized in that**:

the first and third IDTs (52b,52d) located on both sides of the surface acoustic wave propagating direction are connected to the unbalanced terminal (53);
the second IDT (52c) includes first and second IDT sections (52c1,52c2) divided in the surface acoustic wave propagating direction, the first and second IDT sections (52c1,52c2) are respectively electrically connected to the first and second balanced signal terminals (57,59), and the first to third IDTs (52b-52d) are constructed to set a phase of a signal emanating from the unbalanced terminal (53) to the first balanced signal terminal (57) reversed by 180 degrees with respect to a phase of a signal emanating from the unbalanced terminal (53) to the second balanced signal terminal (59);
in an area where the first to third IDTs (52b-52d) are adjacent one another in the surface acoustic wave propagating direction with a gap interposed therebetween, the respective IDTs have narrow pitch electrode finger sections (N) at areas near the gap; and
the electrode finger pitch of any narrow pitch electrode finger section (N) of the first and third IDTs (52b,52d) connected to the unbalanced signal terminal (53) being set as P1, the number of electrode fingers of any narrow pitch electrode finger section (N) thereof being set as N1, the electrode finger pitch of any narrow pitch electrode finger section (N) of the second IDT (52c) whose first and second IDT sections (52c1,52c2) are respectively connected to the first and second balanced signal terminal (57,59) being set as P2, and the number of electrode fingers of the narrow pitch electrode finger section (N) thereof being set as N2, so that the following relations:

$$P1 \neq P2;$$

and

$$N1 < N2$$

are satisfied.

15. The balanced-type surface acoustic wave filter according to Claim 14, **characterized in that** P1<P2 is satisfied.

**Patentansprüche**

1. Akustischer Oberflächenwellenfilter vom symmetrischen Typ (1), welcher mit einem unsymmetrischen Anschluss (3) und einem ersten und einem zweiten symmetrischen Anschluss (7, 9) verbunden ist, und mit einer symmetrisch-nachunsymmetrisch Wandlerfunktion bereitgestellt ist, umfassend:

ein piezoelektrisches Substrat (2),
einen ersten akustischen Oberflächenwellenfilterabschnitt (4), welcher einen ersten bis dritten IDT (4a bis 4c) umfasst, welche entlang einer Fortpflanzungsrichtung einer akustischen Oberflächenwelle auf dem piezoelektrischen Substrat angeordnet sind, wobei der zweite IDT (4b) in der Mitte oder der erste und der dritte IDT (4a, 4c) auf beiden Seiten mit dem unsymmetrischen Anschluss (3) verbunden sind und der erste und der dritte IDT (4a, 4c) auf beiden Seiten oder der zweite IDT (4b) in der Mitte mit dem ersten symmetrischen Anschluss (7) verbunden sind, und

einen zweiten akustischen Oberflächenwellenfilterabschnitt (5), welcher einen ersten bis dritten IDT (5a bis 5c) umfasst, welche in der Fortpflanzungsrichtung einer akustischen Oberflächenwelle auf dem piezoelektrischen Substrat angeordnet sind, wobei der zweite IDT (5b) in der Mitte oder der erste und der dritte IDT (5a, 5c) auf beiden Seiten mit dem unsymmetrischen Anschluss (3) verbunden sind, der erste und der dritte IDT (5a, 5c) auf beiden Seiten oder der zweite IDT (5b) in der Mitte mit dem zweiten symmetrischen Anschluss (9) verbunden sind und der zweite akustische Oberflächenwellenfilterabschnitt (5) so aufgebaut ist, dass er eine Phase eines Ausgangssignals zu einem Eingangssignal aufweist, welche um 180 Grad hinsichtlich des ersten akustischen Oberflächenwellenfilterabschnitts (4) verschieden ist, wobei der akustische Oberflächenwellenfilter vom symmetrischen Typ (1) **dadurch gekennzeichnet ist, dass**:

> in dem ersten und in dem zweiten akustischen Oberflächenwellenfilterabschnitt (4, 5), in einem Paar IDT (4a, 4b; 4b, 4c; 5a, 5b; 5b, 5c), welche in der Fortpflanzungsrichtung einer akustischen Oberflächenwelle mit einer dazwischen angeordneten Lücke einander benachbart sind, ein Abschnitt, bei welchem das Rastermaß eines Abschnitts der Elektrodenfinger, welcher einen Elektrodenfinger umfasst, welcher der Lücke gegenüber steht, kleiner ist als das Rastermaß der Elektrodenfinger eines Hauptteils des IDT, als ein Elektrodenfingerabschnitt mit engem Rastermaß (N) eingerichtet ist, und
>
> das Elektrodenfinger-Rastermaß des Elektrodenfingerabschnitts mit engem Rastermaß (N) eines IDT, welcher mit dem unsymmetrischen Anschluss (3) des ersten und des zweiten akustischen Oberflächenwellenfilterabschnitts (4, 5) verbunden ist, als P1 eingerichtet ist, das Elektrodenfinger-Rastermaß eines Elektrodenfingerabschnitts mit engem Rastermaß (N) des IDT, welcher mit dem symmetrischen Anschluss (7, 9) verbunden ist, als P2 eingerichtet ist, die Anzahl der Elektrodenfinger des Hauptelektrodenfingerabschnitts außerhalb des Elektrodenfingerabschnitts mit engem Rastermaß eines IDT, welcher mit dem unsymmetrischen Anschluss (3) des ersten und des zweiten akustischen Oberflächenwellenfilterabschnitts (4, 5) verbunden ist, als K1 eingerichtet ist, und die Anzahl der Elektrodenfinger des Hauptelektrodenfingerabschnitts außerhalb des Elektrodenfingerabschnitts mit engem Rastermaß eines IDT, welcher mit dem symmetrischen Anschluss (7, 9) verbunden ist, als K2 eingerichtet ist, so dass die folgenden Relationen:

$$P1 > P2;$$

und

$$1{,}12 \leq K1/K2 \leq 1{,}65$$

erfüllt sind.

2. Akustischer Oberflächenwellenfilter vom symmetrischen Typ (1) nach Anspruch 1, wobei, wenn die Anzahl Elektrodenfinger des Elektrodenfingerabschnitts mit engem Rastermaß (N) des IDT, welcher mit dem unsymmetrischen Anschluss (3) des ersten und des zweiten akustischen Oberflächenwellenfilterabschnitts (4, 5) verbunden ist, als K1 n eingerichtet ist, und die Anzahl Elektrodenfinger des Elektrodenfingerabschnitts mit engem Rastermaß (N) des IDT, welcher mit dem symmetrischen Anschluss (7, 9) verbunden ist, als K2n eingerichtet ist, die folgenden Relationen:

$$P1 > P2;$$

$$K1n = K2n;$$

und

$$1{,}12 \leq K1/K2 \leq 1{,}65$$

erfüllt sind.

3. Akustischer Oberflächenwellenfilter vom symmetrischen Typ (1) nach Anspruch 1 oder 2, wobei, wenn ein Metallisierungsverhältnis in dem ersten und in dem zweiten akustischen Oberflächenwellenfilterabschnitt (4, 5) als d eingerichtet ist und eine Querbreite der Elektrodenfinger als W eingerichtet ist, $67{,}4\ \lambda l \leq W/d \leq 74{,}3\lambda l$ (wobei $\lambda l$ eine Wellenlänge des IDT bezeichnet) erfüllt ist.

4. Akustischer Oberflächenwellenfilter vom symmetrischen Typ (41 / 50), welcher mit einem symmetrischen Anschluss (43) und einem ersten und einem zweiten unsymmetrischen Anschluss (47, 49) verbunden ist, und mit einer symmetrisch-nachunsymmetrisch Wandlerfunktion bereitgestellt ist, umfassend:

ein piezoelektrisches Substrat, und
einen ersten bis dritten IDT (42b bis 42d), welche in einer Fortpflanzungsrichtung einer akustischen Oberflächenwelle auf dem piezoelektrischen Substrat angeordnet sind, wobei der akustische Oberflächenwellenfilter vom symmetrischen Typ (41 / 50) **dadurch gekennzeichnet ist, dass**:

der zweite IDT (42c) mit dem unsymmetrischen Anschluss (43) verbunden ist und der erste und der dritte IDT (42b, 42d) auf beiden Seiten mit dem ersten bzw. mit dem zweiten symmetrischen Anschluss (47, 49) verbunden sind,
in einem Bereich, bei welchem der erste bis dritte IDT (42b bis 42d) einander benachbart sind, die jeweiligen IDT Elektrodenfingerabschnitte mit engem Rastermaß (N) aufweisen, und ein Elektrodenfinger-Rastermaß des Elektrodenfingerabschnitts mit engem Rastermaß (N) kleiner eingerichtet ist als ein Elektrodenfinger-Rastermaß eines Hauptelektrodenfingerabschnitts des IDT, welcher mit Elektrodenfingern mit engem Rastermaß bereitgestellt ist,
eine Phase des ersten IDT (42b) um 180 Grad hinsichtlich einer Phase des dritten IDT (42d) gedreht ist, und
das Elektrodenfinger-Rastermaß eines Elektrodenfingerabschnitts mit engem Rastermaß (N) des zweiten IDT (42c), welcher in der Mitte angeordnet ist und als P1 eingerichtet ist, das Elektrodenfinger-Rastermaß eines Elektrodenfingerabschnitts mit engem Rastermaß (N) des ersten und des dritten IDT (42b, 42d), welcher als P2 eingerichtet ist, die Anzahl der Elektrodenfinger des Hauptelektrodenfingerabschnitts außerhalb des Elektrodenfingerabschnitts mit engem Rastermaß des zweiten IDT (42c) als K1 eingerichtet ist, und die Anzahl der Elektrodenfinger des Hauptelektrodenfingerabschnitts außerhalb des Elektrodenfingerabschnitts mit engem Rastermaß des ersten und des dritten IDT (42b, 42d) als K2 eingerichtet ist, so dass die folgenden Relationen:

$$P1 > P2;$$

und

$$1{,}12 \leq K1/K2 \leq 1{,}65$$

erfüllt sind.

5. Akustischer Oberflächenwellenfilter vom symmetrischen Typ (41/ 50) nach Anspruch 4, wobei, wenn die Anzahl Elektrodenfinger des Elektrodenfingerabschnitts mit engem Rastermaß (N) des zweiten IDT (42c) als K1 n eingerichtet ist und die Anzahl Elektrodenfinger des Elektrodenfingerabschnitts mit engem Rastermaß (N) des ersten und des dritten IDT (42b, 42d) als K2n eingerichtet ist, die folgenden Relationen:

$$P1 > P2;$$

$$K1n = K2n;$$

und

$$1{,}12 \leq K1/K2 \leq 1{,}65$$

erfüllt sind.

6. Akustischer Oberflächenwellenfilter vom symmetrischen Typ (41/ 50) nach Anspruch 4 oder 5, wobei, wenn ein Metallisierungsverhältnis in dem ersten bis dritten IDT (42b bis 42d) als d eingerichtet ist und eine Querbreite eines Elektrodenfingers als W eingerichtet ist, $134{,}8\ \lambda l \leq W/d \leq 148{,}6 \lambda l$ (wobei $\lambda l$ eine Wellenlänge des IDT bezeichnet) erfüllt ist.

7. Akustischer Oberflächenwellenfilter vom symmetrischen Typ (51/ 70), welcher mit einem unsymmetrischen Anschluss (53) und einem ersten und einem zweiten symmetrischen Anschluss (57, 59) verbunden ist, und mit einer symmetrisch-nachunsymmetrisch Wandlerfunktion bereitgestellt ist, umfassend:

ein piezoelektrisches Substrat, und
einen ersten bis dritten IDT (52b bis 52d), welche in einer Fortpflanzungsrichtung einer akustischen Oberflächenwelle auf dem piezoelektrischen Substrat angeordnet sind, wobei der akustische Oberflächenwellenfilter vom symmetrischen Typ **dadurch gekennzeichnet ist, dass**:

der erste und der dritte IDT (52b, 52d), welche auf beiden Seiten in der Fortpflanzungsrichtung einer akustischen Oberflächenwelle angeordnet sind, mit dem unsymmetrischen Anschluss (53) verbunden sind,

der zweite IDT (52c) einen ersten und einen zweiten IDT-Abschnitt (52c1, 52c2) aufweist, welche in der Fortpflanzungsrichtung einer akustischen Oberflächenwelle aufgeteilt sind, der erste und der zweite IDT-Abschnitt (52c1, 52c2) mit den ersten bzw. mit dem zweiten symmetrischen Signalanschluss (57, 59) elektrisch verbunden sind, und der erste bis dritte IDT (52b bis 52d) aufgebaut sind, eine Phase eines Signals, welches von dem unsymmetrischen Anschluss (53) an den ersten symmetrischen Signalanschluss (57) ausgeht, um 180 Grad hinsichtlich einer Phase eines Signals gedreht einzustellen, welches von dem unsymmetrischen Anschluss (53) an den zweiten symmetrischen Signalanschluss (59) ausgeht,

in einem Bereich, bei welchem der erste bis dritte IDT (52b bis 52d) in der Fortpflanzungsrichtung einer akustischen Oberflächenwelle mit einer dazwischen angeordneten Lücke einander benachbart sind, mehrere Elektrodenfinger nahe der Lücke einem Elektrodenfingerabschnitt mit engem Rastermaß (N) entsprechen, wobei ein Rastermaß der Elektrodenfinger relativ klein ist, und

das Elektrodenfinger-Rastermaß des Elektrodenfingerabschnitts mit engem Rastermaß (N) des ersten und des dritten IDT (52b, 52d), welche mit dem unsymmetrischen Signalanschluss (53) verbunden sind, als P1 eingerichtet ist, das Elektrodenfinger-Rastermaß eines Elektrodenfingerabschnitts mit engem Rastermaß (N) des zweiten IDT (52c), dessen erster und zweiter IDT-Abschnitt (52c1, 52c2) mit dem ersten bzw. mit dem zweiten symmetrischen Signalanschluss (57, 59) verbunden sind, als P2 eingerichtet ist, die Anzahl der Elektrodenfinger des Hauptelektrodenfingerabschnitts außerhalb des Elektrodenfingerabschnitts mit engem Rastermaß des ersten und des dritten IDT (52b, 52d) als K1 eingerichtet ist, und die Anzahl der Elektrodenfinger des Hauptelektrodenfingerabschnitts außerhalb des Elektrodenfingerabschnitts mit engem Rastermaß des zweiten IDT (52c) als K2 eingerichtet ist, so dass die folgenden Relationen:

$$P1 > P2;$$

und

$$1{,}12 \leq K1/K2 \leq 1{,}65$$

erfüllt sind.

8. Akustischer Oberflächenwellenfilter vom symmetrischen Typ (51/ 70) nach Anspruch 7, wobei, wenn die Anzahl Elektrodenfinger des Elektrodenfingerabschnitts mit engem Rastermaß (N) des ersten und des dritten IDT (52b, 52d) als K1n eingerichtet ist und die Anzahl Elektrodenfinger des Elektrodenfingerabschnitts mit engem Rastermaß (N) des zweiten IDT (52c) als K2n eingerichtet ist, die folgenden Relationen:

$$P1 > P2;$$

$$K1n = K2n;$$

und

$$1{,}12 \leq K1/K2 \leq 1{,}65$$

erfüllt sind.

9. Akustischer Oberflächenwellenfilter vom symmetrischen Typ (51/ 70) nach Anspruch 7 oder 8, wobei, wenn eine Metallisierung in dem ersten bis dritten IDT als d eingerichtet ist und eine Querbreite eines Elektrodenfingers als W eingerichtet ist, $134{,}8\,\lambda\mathrm{I} \leq W/d \leq 148{,}6\,\lambda\mathrm{I}$ (wobei $\lambda\mathrm{I}$ eine Wellenlänge des IDT bezeichnet) erfüllt ist.

10. Akustischer Oberflächenwellenfilter vom symmetrischen Typ, welcher mit einem unsymmetrischen Anschluss (3) und einem ersten und einem zweiten symmetrischen Anschluss (7, 9) verbunden ist, und mit einer symmetrisch-nachunsymmetrisch Wandlerfunktion bereitgestellt ist, umfassend:

ein piezoelektrisches Substrat (2),
einen ersten akustischen Oberflächenwellenfilterabschnitt (4), welcher einen ersten bis dritten IDT (4a bis 4c) umfasst, welche entlang einer Fortpflanzungsrichtung einer akustischen Oberflächenwelle auf dem piezoelektrischen Substrat angeordnet sind, wobei der zweite IDT (4b) in der Mitte oder der erste und der dritte IDT (4a, 4c) auf beiden Seiten mit dem unsymmetrischen Anschluss (3) verbunden sind und der erste und der dritte IDT (4a, 4c) auf beiden Seiten oder der zweite IDT (4b) in der Mitte mit dem ersten symmetrischen Anschluss (7) verbunden sind, und

ein zweiter akustischer Oberflächenwellenfilterabschnitt (5), welcher einen ersten bis dritten IDT (5a bis 5c) umfasst, welche in der Fortpflanzungsrichtung einer akustischen Oberflächenwelle auf dem piezoelektrischen Substrat angeordnet sind, wobei der zweite IDT (5b) in der Mitte oder der erste und der dritte IDT (5a, 5c) auf beiden Seiten mit dem unsymmetrischen Anschluss (3) verbunden sind, der erste und der dritte IDT (5a, 5c) auf beiden Seiten oder der zweite IDT (5b) in der Mitte mit dem zweiten symmetrischen Anschluss (9) verbunden sind und der zweite akustische Oberflächenwellenfilterabschnitt (5) so aufgebaut ist, dass er eine Phase eines Ausgangssignals zu einem Eingangssignal aufweist, welche um 180 Grad hinsichtlich des ersten akustischen Oberflächenwellenfilterabschnitts (4) verschieden ist, wobei der akustische Oberflächenwellenfilter vom symmetrischen Typ **dadurch gekennzeichnet ist, dass**:

in dem ersten und in dem zweiten akustischen Oberflächenwellenfilterabschnitt (4, 5), in einem Paar IDT (4a, 4b; 4b, 4c; 5a, 5b; 5b, 5c), welche in der Fortpflanzungsrichtung einer akustischen Oberflächenwelle mit einer dazwischen angeordneten Lücke einander benachbart sind, ein Abschnitt, bei welchem das Rastermaß eines Abschnitts der Elektrodenfinger, welcher einen Elektrodenfinger umfasst, welcher der Lücke gegenüber steht, kleiner ist als das Rastermaß von Elektrodenfingern eines Hauptteils des IDT, als ein Elektrodenfingerabschnitt mit engem Rastermaß (N) eingerichtet ist, und

das Elektrodenfinger-Rastermaß des Elektrodenfingerabschnitts mit engem Rastermaß (N) eines IDT, welcher mit dem unsymmetrischen Anschluss (3) des ersten und des zweiten akustischen Oberflächenwellenfilterabschnitts (4, 5) verbunden ist, als P1 eingerichtet ist, die Anzahl Elektrodenfinger seines Elektrodenfingerabschnitts mit engem Rastermaß (N) als N1 eingerichtet ist, das Elektrodenfinger-Rastermaß des Elektrodenfingerabschnitts mit engem Rastermaß (N) des IDT, welcher mit dem ersten und mit dem zweiten symmetrischen Anschluss (7, 9) verbunden ist, als P2 eingerichtet ist, und die Anzahl Elektrodenfinger seines Elektrodenfingerabschnitts mit engem Rastermaß (N) als N2 eingerichtet ist, so dass die folgenden Relationen:

$$P1 \neq P2;$$

und

$$N1 < N2$$

erfüllt sind.

11. Akustischer Oberflächenwellenfilter vom symmetrischen Typ nach Anspruch 10, **dadurch gekennzeichnet, dass** P1 < P2 erfüllt ist.

12. Akustischer Oberflächenwellenfilter vom symmetrischen Typ, welcher mit einem symmetrischen Anschluss (43) und mit einem ersten und mit einem zweiten symmetrischen Anschluss (47, 49) verbunden ist, und mit einer symmetrisch-nachunsymmetrisch Wandlerfunktion bereitgestellt ist, umfassend:

ein piezoelektrisches Substrat, und einen ersten bis dritten IDT (52b bis 52d), welche in einer Fortpflanzungsrichtung einer akustischen Oberflächenwelle auf dem piezoelektrischen Substrat angeordnet sind, wobei der akustische Oberflächenwellenfilter vom symmetrischen Typ **dadurch gekennzeichnet ist, dass**:

der zweite IDT (42c) mit dem unsymmetrischen Anschluss (43) verbunden ist und der erste und der dritte IDT (42b, 42d) mit dem ersten bzw. mit dem zweiten symmetrischen Anschluss (47, 49) verbunden sind, in einem Bereich, bei welchem der erste bis dritte IDT (42b bis 42d) einander benachbart sind, die jeweiligen IDT Elektrodenfingerabschnitte mit engem Rastermaß (N) aufweisen, und ein Elektrodenfinger-Rastermaß des Elektrodenfingerabschnitts mit engem Rastermaß (N) kleiner eingerichtet ist als ein Elektrodenfinger-Rastermaß eines Hauptelektrodenfingerabschnitts des IDT, welcher mit Elektrodenfingern mit engem Rastermaß bereitgestellt ist, die Phase des ersten IDT (42b) um 180 Grad hinsichtlich der Phase des dritten IDT (42d) gedreht ist, und das Elektrodenfinger-Rastermaß eines Elektrodenfingerabschnitts mit engem Rastermaß (N) des zweiten IDT (42c), welcher mit dem unsymmetrischen Anschluss (43) verbunden ist, als P1 eingerichtet ist, die Anzahl Elektrodenfinger seines Elektrodenfingerabschnitts mit engem Rastermaß (N) als N1 eingerichtet ist, das Elektrodenfinger-Rastermaß eines Elektrodenfingerabschnitts mit engem Rastermaß (N) des ersten und des dritten IDT (42b, 42d), welche mit dem ersten und mit dem zweiten symmetrischen Anschluss (47, 49) verbunden sind, als P2 eingerichtet ist, und die Anzahl Elektrodenfinger seines Elektrodenfingerabschnitts mit engem Rastermaß (N) als N2 eingerichtet ist, so dass die folgenden Relationen:

$$P1 \neq P2;$$

und

$$N1 < N2$$

erfüllt sind.

13. Akustischer Oberflächenwellenfilter vom symmetrischen Typ nach Anspruch 12, **dadurch gekennzeichnet, dass** P1 < P2 erfüllt ist.

14. Akustischer Oberflächenwellenfilter vom symmetrischen Typ, welcher mit einem unsymmetrischen Anschluss (53) und einem ersten und einem zweiten symmetrischen Anschluss (57, 59) verbunden ist, und mit einer symmetrisch-nachunsymmetrisch Wandlerfunktion bereitgestellt ist, umfassend:

ein piezoelektrisches Substrat, und einen ersten bis dritten IDT (52b bis 52d), welche in einer Fortpflanzungsrichtung einer akustischen Oberflächenwelle auf dem piezoelektrischen Substrat angeordnet sind, wobei der akustische Oberflächenwellenfilter vom symmetrischen Typ **dadurch gekennzeichnet ist, dass**:

der erste und der dritte IDT (52b, 52d), welche auf beiden Seiten der Fortpflanzungsrichtung einer akustischen Oberflächenwelle angeordnet sind, mit dem unsymmetrischen Anschluss (53) verbunden sind, der zweite IDT (52c) einen ersten und einen zweiten IDT-Abschnitt (52c1, 52c2) aufweist, welche in der Fortpflanzungsrichtung einer akustischen Oberflächenwelle aufgeteilt sind, der erste und der zweite IDT-Abschnitt (52c1, 52c2) mit den ersten bzw. mit dem zweiten symmetrischen Signalanschluss (57, 59) elektrisch verbunden sind, und der erste bis dritte IDT (52b bis 52d) aufgebaut sind, eine Phase eines Signals, welches von dem unsymmetrischen Anschluss (53) an den ersten symmetrischen Signalanschluss (57) ausgeht, um 180 Grad hinsichtlich einer Phase eines Signals gedreht einzustellen, welches von dem unsymmetrischen Anschluss (53) an den zweiten symmetrischen Signalanschluss (59) ausgeht,

in einem Bereich, bei welchem der erste bis dritte IDT (52b bis 52d) in der Fortpflanzungsrichtung einer akustischen Oberflächenwelle mit einer dazwischen angeordneten Lücke einander benachbart sind, die jeweiligen IDT Elektrodenfingerabschnitte mit engem Rastermaß (N) in Bereichen nahe der Lücke aufweisen, und

das Elektrodenfinger-Rastermaß eines Elektrodenfingerabschnitts mit engem Rastermaß (N) des ersten und des dritten IDT (52b, 52d), welche mit dem unsymmetrischen Signalanschluss (53) verbunden sind, als P1 eingerichtet ist, die Anzahl Elektrodenfinger jedes seiner Elektrodenfingerabschnitte mit engem Rastermaß (N) als N1 eingerichtet ist, das Elektrodenfinger-Rastermaß eines Elektrodenfingerabschnitts mit engem Rastermaß (N) des zweiten IDT (52c), dessen erster und zweiter IDT-Abschnitt (52c1, 52c2) mit dem ersten bzw. mit dem zweiten symmetrischen Anschluss (57, 59) verbunden sind, als P2 eingerichtet ist, und die Anzahl Elektrodenfinger seines Elektrodenfingerabschnitts mit engem Rastermaß (N) als N2 eingerichtet ist, so dass die folgenden Relationen:

$$P1 \neq P2;$$

und

$$N1 < N2$$

erfüllt sind.

15. Akustischer Oberflächenwellenfilter vom symmetrischen Typ nach Anspruch 14, **dadurch gekennzeichnet, dass** P1 < P2 erfüllt ist.

**Revendications**

1. Filtre à ondes acoustiques de surface de type équilibré (1) relié à une borne non équilibrée (3) et à des première et seconde bornes équilibrées (7, 9) et muni d'une fonction de conversion équilibre-déséquilibre, comportant :

un substrat piézo-électrique (2) ;
une première section de filtre à ondes acoustiques de surface (4) comprenant des premier à troisième transducteurs interdigitaux (IDT) (4a-4c) disposés le long d'une direction de propagation d'ondes acoustiques de surface sur le substrat piézo-électrique, le second IDT (4b) au centre ou les premier et troisième IDT (4a, 4c) sur les deux côtés étant reliés à la borne non équilibrée (3), et les premier et troisième IDT (4a, 4c) sur les deux côtés ou le second IDT (4b) au centre étant reliés à la première borne équilibrée (7) ; et
une seconde section de filtre à ondes acoustiques de surface (5) comprenant des premier à troisième IDT (5a-5c) disposés sur le substrat piézo-électrique dans la direction de propagation des ondes acoustiques de surface, le second IDT (5b) au centre ou les premier et troisième IDT (5a, 5c) sur les deux côtés étant reliés à la borne non équilibrée (3), les premier et troisième IDT (5a, 5c) sur les deux côtés ou le second IDT (5b) au centre étant reliés à la seconde borne équilibrée (9), et la seconde section de filtre à ondes acoustiques de surface (5) étant réalisée pour avoir une phase d'un signal de sortie par rapport à un signal d'entrée différente de 180° par rapport à la première section de filtre à ondes acoustiques de surface (4), le filtre à ondes acoustiques de surface de type équilibré (1) étant **caractérisé en ce que** :

dans les première et seconde sections de filtre à ondes acoustiques de surface (4, 5), dans une paire d'IDT (4a, 4b ; 4b, 4c ; 5a, 5b ; 5b, 5c) adjacente l'une à l'autre avec un intervalle entre elles dans la direction de propagation des ondes acoustiques de surface, une section où le pas d'une partie des doigts d'électrode comprenant un doigt d'électrode faisant face à l'intervalle est inférieur au pas des doigts d'électrode d'une partie principale de l'IDT est déterminée en tant que section de doigt d'électrode à pas réduit (N) ; et
le pas de doigt d'électrode de la section de doigt d'électrode à pas réduit (N) d'un IDT quelconque relié à la borne non équilibrée (3) des première et seconde sections de filtre à ondes acoustiques de surface (4, 5) étant déterminé comme étant P1, le pas de doigt d'électrode de l'une quelconque des sections de doigt d'électrode à pas réduit (N) de l'IDT relié à la borne équilibrée (7, 9) étant déterminé comme étant P2, le nombre de doigts d'électrode de la section principale de doigt d'électrode en dehors de la section de doigt d'électrode à pas réduit d'un IDT quelconque relié à la borne non équilibrée (3) des première et seconde sections de filtre à ondes acoustiques de surface (4, 5) étant déterminé comme étant K1, et le nombre de doigts d'électrode de la section principale de doigt d'électrode en dehors de la section de doigt d'électrode à pas réduit d'un IDT quelconque relié à la borne équilibrée (7, 9) étant déterminé comme étant K2, de sorte que les équations suivantes sont satisfaites :

$$P1 > P2 ;$$

et

$$1,12 \leq K1/K2 \leq 1,65.$$

2. Filtre à ondes acoustiques de surface de type équilibré (1) selon la revendication 1, dans lequel, lorsque le nombre de doigts d'électrode de la section de doigt d'électrode à pas réduit (N) de l'IDT relié à la borne non équilibrée (3) des première et seconde sections de filtre à ondes acoustiques de surface (4, 5) est déterminé comme étant K1n, et le nombre de doigts d'électrode de la section de doigt d'électrode à pas réduit (N) de l'IDT relié à la borne équilibrée (7, 9) est déterminé comme étant K2n, les équations suivantes sont satisfaites :

$$P1 > P2 ;$$

$$K1n = K2n ;$$

et

$$1,12 \leq K1/K2 \leq 1,65.$$

3. Filtre à ondes acoustiques de surface de type équilibré (1) selon la revendication 1 ou 2, dans lequel, lorsqu'un rapport de métallisation dans les première et seconde sections de filtre à ondes acoustiques de surface (4, 5) est déterminé comme étant d et qu'une largeur de croisement de doigt d'électrode est déterminée comme étant W, $67,4\lambda I \leq W/d \leq 74,3\lambda I$ (où $\lambda I$ désigne une longueur d'onde de l'IDT) est satisfaite.

**4.** Filtre à ondes acoustiques de surface de type équilibré (41/50) relié à une borne équilibrée (43) et aux première et seconde bornes non équilibrées (47, 49) et muni d'une fonction de conversion équilibre-déséquilibre, comportant :

un substrat piézo-électrique ; et
des premier à troisième IDT (42b-42d) disposés sur le substrat piézo-électrique dans une direction de propagation d'ondes acoustiques de surface, le filtre à ondes acoustiques de surface de type équilibré (41/50) étant **caractérisé en ce que** :

le second IDT (42c) est relié à la borne non équilibrée (43) et les premier et troisième IDT (42b, 42d) sur les deux côtés sont respectivement reliés aux première et seconde bornes équilibrées (47, 49) ;
**en ce que**, dans une région où les premier à troisième IDT (42b-42d) sont adjacents l'un à l'autre, les IDT respectifs possèdent des sections de doigt d'électrode à pas réduit (N) et un pas de doigt d'électrode de la section de doigt d'électrode à pas réduit (N) est déterminé inférieur à un pas de doigt d'électrode de la section principale de doigt d'électrode de l'IDT muni de doigts d'électrode à pas réduit ;
**en ce qu'**une phase du premier IDT (42b) est inversée de 180 degrés par rapport à une phase du troisième IDT (42d) ; et
le pas de doigt d'électrode d'une section de doigt d'électrode à pas réduit (N) quelconque du second IDT (42c) situé au centre étant déterminé comme étant P1, le pas de doigt d'électrode d'une section de doigt d'électrode à pas réduit (N) quelconque des premier et troisième IDT (42b, 42d) étant déterminé comme étant P2, le nombre de doigts d'électrode de la section principale de doigt d'électrode en dehors de la section de doigt d'électrode à pas réduit du second IDT (42c) étant déterminé comme étant K1, et le nombre de doigts d'électrode de la section principale de doigt d'électrode en dehors de la section de doigt d'électrode à pas réduit des premier et troisième IDT (42b, 42d) étant déterminé comme étant K2, de sorte que les équations suivantes sont satisfaites :

$$P1 > P2 \; ;$$

et

$$1{,}12 \leq K1/K2 \leq 1{,}65.$$

**5.** Filtre à ondes acoustiques de surface de type équilibré (41/50) selon la revendication 4, dans lequel, lorsque le nombre de doigts d'électrode de la section de doigt d'électrode à pas réduit (N) du second IDT (42c) est déterminé comme étant K1n, et le nombre de doigts d'électrode de la section de doigt d'électrode à pas réduit (N) des premier et troisième IDT (42b, 42d) est déterminé comme étant K2n, les équations suivantes sont satisfaites :

$$P1 > P2 \; ;$$

et

$$1{,}12 \leq K1/K2 \leq 1{,}65.$$

**6.** Filtre à ondes acoustiques de surface du type équilibré (41/50) selon la revendication 4 ou 5, dans lequel, lorsqu'un rapport de métallisation dans les premier à troisième IDT (42b-42d) est déterminé comme étant d et qu'une largeur de croisement de doigt d'électrode est déterminée comme étant W, $134{,}8 \, \lambda I \leq W/d \leq 148{,}6 \, \lambda I$ (où $\lambda I$ désigne une longueur d'onde de l'IDT) est satisfaite.

**7.** Filtre à ondes acoustiques de surface du type équilibré (51/70) relié à une borne non équilibrée (53) et aux première et seconde bornes équilibrées (57, 59) et muni d'une section de conversion équilibre-déséquilibre, comportant :

un substrat piézo-électrique ; et
des premier à troisième IDT (52b-52d) disposés sur le substrat piézo-électrique dans une direction de propagation d'ondes acoustiques de surface, le filtre à ondes acoustiques de surface de type équilibré étant **caractérisé en ce que** :

les premier et troisième IDT (52b, 52d) situés sur les deux côtés dans la direction de propagation d'ondes acoustiques de surface sont reliés à la borne non équilibrée (53) ;
le second IDT (52c) comprend des première et seconde sections d'IDT (52c1, 52c2) divisées dans la direction de propagation d'ondes acoustiques de surface, les première et seconde sections d'IDT (52c1, 52c2) sont respectivement reliées électriquement aux première et seconde bornes de signal équilibrée (57, 59), et les premier à troisième IDT (52b-52d) sont réalisés pour déterminer une phase d'un signal provenant de la borne non équilibrée (53) à la première borne de signal équilibrée (57) inversée de 180 degrés par rapport à une phase d'un signal provenant de la borne non équilibrée (53) à la seconde borne de signal équilibrée (59) ;

dans une région où les premier à troisième IDT (52b-52d) sont adjacents l'un à l'autre dans la direction de propagation d'ondes acoustiques de surface avec un intervalle entre eux, une pluralité de doigts d'électrode proches de l'intervalle correspond à une section de doigt d'électrode à pas réduit (N) où un pas de doigt d'électrode est relativement petit ; et

le pas de doigt d'électrode dans la section de doigt d'électrode à pas réduit (N) des premier et troisième IDT (52b, 52d) reliés à la borne de signal non équilibrée (53) étant déterminé comme étant P1, le pas de doigt d'électrode d'une section de doigt d'électrode à pas réduit quelconque (N) du second IDT (52c) dont les première et seconde sections d'IDT (52c1, 52c2) sont respectivement reliées aux première et seconde bornes de signal équilibrées (57, 59) étant déterminé comme étant P2, le nombre de doigts d'électrode de la section de doigt d'électrode principale en dehors de la section de doigt d'électrode à pas réduit des premier et troisième IDT (52b, 52d) étant déterminé comme étant K1, et le nombre de doigts d'électrode de la section de doigt d'électrode principale en dehors de la section de doigt d'électrode à pas réduit du second IDT (52c) étant déterminé comme étant K2, de sorte que les équations suivantes sont satisfaites :

$$P1 > P2 \ ;$$

et

$$1{,}12 \leq K1/K2 \leq 1{,}65.$$

**8.** Filtre à ondes acoustiques de surface de type équilibré (51/70) selon la revendication 7, dans lequel, lorsque le nombre de doigts d'électrode de la section de doigt d'électrode à pas réduit (N) des premier et troisième IDT (52b, 52d) est déterminé comme étant K1n, et le nombre de doigts d'électrode de la section de doigt d'électrode à pas réduit (N) du second IDT (52c) est déterminé comme étant K2n, les équations suivantes sont satisfaites :

$$P1 > P2 \ ;$$

$$K1n = K2n \ ;$$

et

$$1{,}12 \leq K1/K2 \leq 1{,}65.$$

**9.** Filtre à ondes acoustiques de surface de type équilibré (51/70) selon la revendication 7 ou 8, dans lequel, lorsqu'une métallisation dans les premier à troisième IDT est déterminée comme étant d et qu'une largeur de croisement de doigt d'électrode est déterminée comme étant W, $134{,}8 \ \lambda I \leq W/d \leq 148{,}6 \ \lambda I$ (où $\lambda I$ désigne une longueur d'onde de l'IDT) est satisfaite.

**10.** Filtre à ondes acoustiques de surface de type équilibré relié à une borne non équilibrée (3) et à des première et seconde bornes équilibrées (7, 9) et muni d'une fonction de conversion équilibre-déséquilibre, comportant :

un substrat piézo-électrique (2) ;
une première section de filtre à ondes acoustiques de surface (4) comprenant des premier à troisième IDT (4a-4c) disposés sur le substrat piézo-électrique le long d'une direction de propagation d'ondes acoustiques de surface, le second IDT (4b) au centre ou les premier et troisième IDT (4a, 4c) sur les deux côtés étant reliés à la borne non équilibrée (3), et les premier et troisième IDT (4a, 4c) sur les deux côtés ou le second IDT (4b) au centre étant reliés à la première borne équilibrée (7) ; et
une seconde section de filtre à ondes acoustiques de surface (5) comprenant des premier à troisième IDT (5a-5c) disposés sur le substrat piézo-électrique dans la direction de propagation d'ondes acoustiques de surface, le second IDT (5d) au centre ou les premier et troisième IDT (5a, 5c) sur les deux côtés étant reliés à la borne non équilibrée (3), les premier et troisième IDT (5a, 5c) sur les deux côtés ou le second IDT (5b) au centre étant reliés à la seconde borne équilibrée (9), et la seconde section de filtre à ondes acoustiques de surface (5) étant réalisée pour avoir une phase d'un signal de sortie par rapport à un signal d'entrée différente de 180 degrés par rapport à la première section de filtre à ondes acoustiques de surface (4), le filtre à ondes acoustiques de surface de type équilibré étant **caractérisé en ce que** :

dans les première et seconde sections de filtre à ondes acoustiques de surface (4, 5), dans une paire d'IDT (4a, 4b ; 4b, 4c ; 5a, 5b ; 5b, 5c) adjacente l'une de l'autre avec un intervalle entre elles dans la direction de propagation d'ondes acoustiques de surface, une section où le pas d'une partie des doigts d'électrode comprenant un doigt d'électrode faisant face à l'intervalle est inférieur au pas de doigt d'électrode d'une partie principale de l'IDT est déterminée comme étant une section de doigt d'électrode à pas réduit (N) ; et

le pas de doigt d'électrode de la section de doigt d'électrode à pas réduit (N) d'un IDT quelconque relié à la borne non équilibrée (3) des première et seconde sections de filtre à ondes acoustiques de surface (4, 5) étant déterminé comme étant P1, le nombre de doigts d'électrode de la section de doigt d'électrode à pas réduit (N) de celui-ci étant déterminé comme étant N1, le pas de doigt d'électrode de la section de doigt d'électrode à pas réduit (N) de l'IDT relié aux première et seconde bornes équilibrées (7, 9) étant déterminé comme étant P2, et le nombre de doigts d'électrode de la section de doigt d'électrode à pas réduit (N) de celui-ci étant déterminé comme étant N2, de sorte que les équations suivantes sont satisfaites :

$$P1 \neq P2 \ ;$$

et

$$N1 < N2.$$

11. Filtre à ondes acoustiques de surface de type équilibré selon la revendication 10, **caractérisé en ce que** P1 < P2 est satisfaite.

12. Filtre à ondes acoustiques de surface de type équilibré relié à un borne équilibrée (43) et aux première et seconde bornes non équilibrées (47, 49) et muni d'une fonction de conversion équilibre-déséquilibre, comportant :

    un substrat piézo-électrique ; et
    des premier à troisième IDT (42b-42d) disposés sur le substrat piézo-électrique dans une direction de propagation d'ondes acoustiques de surface, le filtre à ondes acoustiques de surface de type équilibré étant **caractérisé en ce que** :

le second IDT (42c) est relié à la borne non équilibrée (43) et les premier et troisième IDT (42b, 42d) sont respectivement reliés aux première et seconde bornes équilibrées (47, 49) ;

dans une région où les premier à troisième IDT (42b-42d) sont adjacents l'un à l'autre, les IDT respectifs possèdent des sections de doigt d'électrode à pas réduit (N) et un pas de doigt d'électrode de la section de doigt d'électrode à pas réduit (N) est déterminé comme étant inférieur au pas de doigt d'électrode d'une section de doigt d'électrode principale de l'IDT muni de doigts d'électrode à pas réduit ;

la phase du premier IDT (42b) est inversée de 180 degrés par rapport à la phase du troisième IDT (42d) ; et

le pas de doigt d'électrode d'une section de doigt d'électrode à pas réduit (N) quelconque du second IDT (42c) relié à la borne non équilibrée (43) étant déterminé comme étant P1, le nombre de doigts d'électrode de la section de doigt d'électrode à pas réduit (N) de celui-ci étant déterminé comme étant N1, le pas de doigt d'électrode d'une section de doigt d'électrode à pas réduit (N) quelconque des premier et troisième IDT (42b, 42d) reliés aux première et seconde bornes équilibrées (47, 49) étant déterminé comme étant P2, et le nombre de doigts d'électrode de la section de doigt d'électrode à pas réduit (N) de celui-ci étant déterminé comme étant N2, de sorte que les équations suivantes sont satisfaites :

$$P1 \neq P2 \ ;$$

et

$$N1 < N2.$$

13. Filtre à ondes acoustiques de surface de type équilibré selon la revendication 12, **caractérisé en ce que** P1 < P2 est satisfaite.

14. Filtre à ondes acoustiques de surface de type équilibré relié à une borne non équilibrée (53) et aux première et seconde bornes équilibrées (57, 59) et muni d'une fonction de conversion équilibre-déséquilibre, comportant :

    un substrat piézo-électrique ; et
    des premier à troisième IDT (52b-52d) disposés sur le substrat piézo-électrique dans une direction de propagation d'ondes acoustiques de surface, le filtre à ondes acoustiques de surface de type équilibré étant **caractérisé en ce que** :

les premier et troisième IDT (52b, 52d) situés sur les deux côtés de la direction de propagation d'ondes acoustiques de surface sont reliés à la borne non équilibrée (53) ; le second IDT (52c) comprend des première et seconde sections d'IDT (52c1, 52c2) divisées dans la direction de propagation d'ondes acoustiques de surface, les première et seconde sections d'IDT (52c1, 52c2) sont respectivement reliées électriquement aux première et seconde bornes de signal équilibrées (57, 59), et les premier à troisième IDT (52b-52d) sont réalisés pour déterminer une phase d'un signal provenant de la borne non équilibrée (53) à la première borne de signal équilibrée (57) inversée de 180 degrés par rapport à une phase d'un signal provenant de la borne non équilibrée (53) à la seconde borne de signal équilibrée (59) ; dans une région où les premier à troisième IDT (52b-52d) sont adjacents l'un à l'autre dans la direction de propagation d'ondes acoustiques de surface avec un intervalle entre eux, les IDT respectifs possèdent des sections de doigt d'électrode à pas réduit (N) dans des régions proches de l'intervalle ; et le pas de doigt d'électrode d'une section de doigt d'électrode à pas réduit quelconque (N) des premier et troisième IDT (52b, 52d) reliés à la borne de signal non équilibrée (53) étant déterminé comme étant P1, le nombre de doigts d'électrode d'une section de doigt d'électrode à pas réduit quelconque (N) de celui-ci étant déterminé comme étant N1, le pas de doigt d'électrode d'une section de doigt d'électrode à pas réduit (N) quelconque du second IDT (52c) dont les première et seconde sections d'IDT (52c1, 52c2) sont respectivement reliées aux première et seconde bornes de signal équilibrées (57, 59) étant déterminé comme étant P2, et le nombre de doigts d'électrode de la section de doigt d'électrode à pas réduit (N) de celui-ci étant déterminé comme étant N2, de sorte que les équations suivantes sont satisfaites :

$$P1 \neq P2 \;;$$

et

$$N1 < N2.$$

15. Filtre à ondes acoustiques de surface de type équilibré selon la revendication 14, **caractérisé en ce que** P1 < P2 est satisfaite.

## FIG.1

## FIG.2

## FIG.3

# FIG.4

(a)

(b)

S11

S22

# FIG.5

# FIG.6

# FIG.7

(a)

(b)

S11

S22

# FIG.8

(a)

(b)

S11

S22

# FIG.9

(a)

(b)

S11

S22

**FIG.10**

(a) S11    (b) S22

**FIG.11**

(a) S11    (b) S22

**FIG.12**

(a) S11    (b) S22

FIG.13

(a)

(b)

S11

S22

FIG.14

## FIG.15

RESONANT MODE
CORRESPONDING TO B
POINT (0TH MODE)

RESONANT MODE
CORRESPONDING TO A
POINT (2ND MODE)

RESONANT MODE
CORRESPONDING TO C
POINT

## FIG.16

## FIG.17

**FIG.18**

**FIG.19**

(a)
(b)

S11
S22

**FIG.20**

(a)
(b)

S11
S22

**FIG.21**

**FIG.22**

**FIG.23**

**FIG.24**

**FIG.25**

**FIG.26**

**FIG.27**

**REFERENCES CITED IN THE DESCRIPTION**

**Patent documents cited in the description**

- JP 2001308672 A
- JP 6204781 A
- JP 11097966 A
- JP 2004048675 A
- US 20030227359 A